# EUROPEAN PATENT APPLICATION

(11) **EP 4 852 702 A1**
(43) Date of publication of application: **09.12.2026**
(21) Application number: 26182245.6
(22) Date of filing: 01.06.2026
(51) Int. Cl.: H10W 72/60, H05K 1/02, H05K 3/28, H10W 90/00, H10W 90/10

(54) **POWER MODULE AND POWER CONVERSION DEVICE**

(30) Priority: 04.06.2025 CN 202510743936
(71) Applicant: Huawei Technologies Co., Ltd., Shenzhen, Guangdong 518129 (CN)
(72) Inventor: SHI, Yidian, Shenzhen, 518129 (CN); LV, Zhen, Shenzhen, 518129 (CN); ZHENG, Sheng, Shenzhen, 518129 (CN); LV, Yafei, Shenzhen, 518129 (CN)
(74) Representative: Epping - Hermann - Fischer

(57) **Abstract**

This application relates to the field of power electronics technologies, and in particular, to a power module and a power conversion device. The power module includes a substrate, at least one group of electronic elements, and at least one interconnection component. Each electronic element is disposed on the substrate, and each group of electronic elements includes a plurality of electronic elements connected in parallel. Each interconnection component includes a conductive sheet and a plurality of conductive structural members, each conductive sheet is spaced apart in a direction perpendicular to the substrate on a side that is of a group of electronic elements and that faces away from the substrate, and a surface that is of a same group of electronic elements and that faces away from the substrate is connected to one conductive sheet via one or more conductive structural members. Each electronic element may be connected to the conductive sheet via the one or more corresponding conductive structural members, so that a circuit connection is more reliable, stress generated by connecting the interconnection component to the plurality of electronic elements can be reduced, and a risk of stress concentration generated by the electronic elements can be reduced, thereby improving structural stability and reliability of the module.

## Description

### TECHNICAL FIELD

This application relates to the field of power electronics technologies, and in particular, to a power module and a power conversion device.

### BACKGROUND

A power module is a core component in a power electronic device, and converts and manages electric energy by integrating one or more power semiconductor components. Therefore, the power module is widely used in fields such as photovoltaics, energy storage, and electric vehicles.

Currently, the power module is developing toward a direction of single-sided plastic packaging with direct cooling welding, which imposes higher requirements on output power and integration of the power module. In a conventional power module of single-sided plastic packaging, there are limited choices for interconnection manners of chips on a side that is of the chips and that faces away from a substrate. Especially when sizes of chips are large, the chips are susceptible to stress, and interconnection between the large-sized chips is challenging.

### SUMMARY

This application provides a power module and a power conversion device. The power module can reduce a size of a substrate occupied by chip interconnection, reduce stress of the module, and improve reliability of the module.

According to a first aspect, this application provides a power module. The power module includes a substrate, at least one group of electronic elements, and at least one interconnection component; each electronic element is disposed on the substrate, and each group of electronic elements includes a plurality of electronic elements; each interconnection component includes a conductive sheet and a plurality of conductive structural members, each conductive sheet is spaced apart in a direction perpendicular to the substrate on a side that is of a group of electronic elements and that faces away from the substrate, and a surface that is of each electronic element in a same group of electronic elements and that faces away from the substrate is connected to one conductive sheet via one or more conductive structural members; and each conductive structural member includes a bottom plate, a top plate, and at least one side plate, the bottom plate is connected to the surface that is of the electronic element and that faces away from the substrate, the top plate is connected to the conductive sheet, and each side plate is connected between the bottom plate and the top plate.

In the foregoing power module, the group of electronic elements may implement circuit interconnection on the side that is of the group of electronic elements and that faces away from the substrate via the interconnection component. Space on the side that is of the plurality of electronic elements and that faces away from the substrate can be used, to save layout space on the surface of the substrate, and avoid occupying large space of the substrate. This helps implement miniaturization of the module. Each electronic element may be connected to the conductive sheet via the one or more corresponding conductive structural members, so that a circuit connection is more reliable, stress generated by connecting the interconnection component to the plurality of electronic elements can be reduced, and a risk of stress concentration generated by the electronic elements can be reduced, thereby improving structural stability and reliability of the module. The at least one side plate in each conductive structural member provides support for a position between the top plate and the bottom plate. There is specific flexibility between the bottom plate and the side plate and between the top plate and the side plate, and an interconnection requirement can be met through structural deformation based on applied force, to reduce requirements on thermal expansion coefficients of different materials in module interconnection, and improve connection reliability.

In an embodiment, in a direction perpendicular to the substrate, orthographic projection of the bottom plate on the electronic element falls within a range of the surface that is of the electronic element and that faces away from the substrate, to reduce impact of connection stress on the electronic element while ensuring a reliable electrical connection. The bottom plate is disposed at a specific distance from an edge of a second electrode of the electronic element.

In an embodiment, the bottom plate is connected to the second electrode of the electronic element through laser welding or reflow soldering, so that solder spread can be allowed in a soldering process. This helps improve feasibility of a soldering operation.

In an embodiment, each electronic element includes a plurality of second electrodes, and the plurality of second electrodes are disposed on the surface that is of the electronic element and that faces away from the substrate; the bottom plate includes a plurality of bottom sub-plates that are spaced apart, and each bottom sub-plate is configured to connect to one second electrode; and in the direction perpendicular to the substrate, orthographic projection of each bottom sub-plate on one electronic element falls within a range of one second electrode. The bottom plate is divided into a plurality of bottom sub-plates to respectively connect to the plurality of second electrodes, so that the bottom plate can be prevented from being short-circuited to another structure of the electronic element, and safety of the module can be improved.

In an embodiment, a part of the electronic elements includes a gate bus, the gate bus is disposed on the surface that is of the electronic element and that faces away from the substrate, and the gate bus is isolated from the second electrode. In the direction perpendicular to the substrate, the orthographic projection of each bottom sub-plate on the electronic element is not in contact with any gate bus, so that a short-circuit risk between the bottom plate and the gate bus can be avoided.

In an embodiment, the bottom plate includes two connection segments and a bulging segment, the bulging segment is connected between the two connection segments, each connection segment is configured to connect to the electronic element, and the bulging segment bulges in a direction away from the electronic element to avoid contact with the electronic element; and in the direction perpendicular to the substrate, a height of the bulging segment is less than a height of the side plate, to avoid interference between the bulging segment and the top plate. Using a surface that is of the bottom plate and that faces away from the top plate as a reference, the surface that is of the bulging segment and that faces away from the top plate is recessed in the direction away from the electronic element to avoid the contact with the electronic element. This reduces a contact area between the bottom plate and the electronic element, reduces the stress generated during connection, and improves connection reliability and feasibility.

In an embodiment, the electronic element includes a gate bus, and the gate bus is disposed on the surface that is of the electronic element and that faces away from the substrate; and a connection direction between the bulging segment and the two connection segments is disposed at an included angle with an extension direction of the gate bus. A surface that is of each bottom sub-plate and that is used to connect to the electronic element is in a block shape, so that the connection reliability can be improved.

In an embodiment, each side plate includes a through hole, and the through hole penetrates two surfaces in a thickness direction of the side plate, to ensure that a plastic packaging material can diffuse to the two surfaces of the side plate in a plastic packaging process of the module, optimize bonding between the plastic packaging material and the side plate, and improve the structural stability and reliability of the module after the plastic packaging material is cured.

In an embodiment, the top plate includes two top sub-plates, the two top sub-plates are spaced apart in a direction parallel to the substrate, and the two top sub-plates are respectively connected to two opposite sides of the bottom plate via two side plates. More balanced force is applied to the top plate and a connection is more reliable.

In an embodiment, in an arrangement direction of the two top sub-plates, an edge that is of each top sub-plate and that is away from a connected side plate includes a plurality of notches that are spaced apart. In the plastic packaging process of the power module, the notch may strengthen bonding strength between the top sub-plate and the plastic packaging material.

In an embodiment, in the arrangement direction of the two top sub-plates, the two top sub-plates extend toward each other or away from each other. When the two top sub-plates extend toward each other, using the two side plates as a reference, the two top sub-plates are respectively connected to two opposite surfaces of the two side plates. When the two top sub-plates extend away from each other, using the two side plates as a reference, the two top sub-plates are respectively connected to two surfaces that are of the two side plates and that are away from each other. Force transferred by the two top sub-plates to the side plates may be basically the same, so that stability of the conductive structural member under the force can be improved.

In an embodiment, in the arrangement direction of the two top sub-plates, an extension direction of one top sub-plate relative to a connected side plate is opposite to an extension direction of the other top sub-plate relative to a connected side plate, so that flexibility of the conductive structural member can be enhanced.

In an embodiment, the top plate and the bottom plate of the conductive structural member are opposite to each other in a direction perpendicular to a thickness of the substrate. This helps reduce a size of the conductive structural member in the direction parallel to the substrate.

In an embodiment, the conductive sheet includes a locking hole, and the locking hole penetrates a surface that is of the conductive sheet and that faces the substrate and a surface that is of the conductive sheet and that faces away from the substrate; and in the direction perpendicular to the substrate, orthographic projection of the locking hole on the substrate does not overlap orthographic projection of the plurality of conductive structural members on the substrate, to avoid the conductive structural members. The locking hole of the conductive sheet may enable the plastic packaging material to diffuse to two surfaces of the conductive sheet in the plastic packaging process of the module, to enhance bonding strength between the conductive sheet and the plastic packaging material.

In an embodiment, the conductive sheet includes a pin part, and the pin part is configured to connect to the substrate; and in the direction perpendicular to the substrate, orthographic projection of the pin part on the substrate is spaced from each electronic element, to avoid structural interference or short circuit with the electronic element.

In an embodiment, the pin part extends to the substrate in the direction perpendicular to the substrate to connect to the substrate. This can simplify a connection structure and facilitate module manufacturing. Alternatively, the pin part is connected to the substrate via a conductive pillar, so that a connection is more reliable.

In an embodiment, a same group of electronic elements includes a first electronic element and a second electronic element; and in the direction perpendicular to the substrate, a distance between the first electronic element and the conductive sheet is less than a distance between the second electronic element and the conductive sheet, and a height of a conductive structural member connected between the first electronic element and the conductive sheet is greater than a height of a conductive structural member connected between the second electronic element and the conductive sheet. When different types of electronic elements are connected in parallel to a same conductive sheet, conductive structural members of different heights may be selected based on heights of different electronic elements, to compensate for a height difference between different electronic elements. Circuit connections between different electronic elements are more feasible and more reliable.

In an embodiment, a same group of electronic elements includes a plurality of first-type electronic elements and a plurality of second-type electronic elements; in a first direction, the plurality of first-type electronic elements are spaced apart, and the plurality of second-type electronic elements are spaced apart; in a second direction, one first-type electronic element and one second-type electronic element are staggered; and the first direction and the second direction are parallel to the substrate and perpendicular to each other. Electronic elements of a same type are spaced apart in the first direction, so that the plurality of electronic elements can be arranged regularly. This helps save arrangement space, balance stress distribution of the substrate, and improve reliability of the module.

According to a second aspect, this application provides a power conversion device. The power conversion device includes a circuit board and any power module according to the first aspect. The power module occupies a smaller volume and has a more reliable structure, so that performance and a service life of the power conversion device can be improved, and device integration can be further implemented.

### BRIEF DESCRIPTION OF DRAWINGS

FIG. 1a is a diagram of a structure of an electric vehicle according to an embodiment of this application;
FIG. 1b is a diagram of a partial power structure of an electric vehicle according to an embodiment of this application;
FIG. 2 is a diagram of a structure of a power conversion device according to an embodiment of this application;
FIG. 3 is a diagram of a partial cross-sectional structure of a power module according to an embodiment of this application;
FIG. 4a is a diagram of a structure of a conductive structural member of a power module according to an embodiment of this application;
FIG. 4b is a diagram of a partial structure of a power module according to an embodiment of this application;
FIG. 5 is a diagram of a partial structure of a power module according to an embodiment of this application;
FIG. 6a is a diagram of a structure of a conductive structural member of a power module according to an embodiment of this application;
FIG. 6b is a diagram of a structure of a conductive structural member of a power module according to an embodiment of this application;
FIG. 7a is a diagram of a structure of a conductive structural member of a power module according to an embodiment of this application;
FIG. 7b is a diagram of a structure of a conductive structural member of a power module according to an embodiment of this application;
FIG. 7c is a diagram of a structure of a conductive structural member of a power module according to an embodiment of this application;
FIG. 8a is a diagram of a structure of a conductive structural member of a power module according to an embodiment of this application;
FIG. 8b is a diagram of a structure of a conductive structural member of a power module according to an embodiment of this application;
FIG. 8c is a diagram of a structure of a conductive structural member of a power module according to an embodiment of this application;
FIG. 9a is a diagram of a structure of a conductive structural member of a power module according to an embodiment of this application;
FIG. 9b is a diagram of a structure of a conductive structural member of a power module according to an embodiment of this application;
FIG. 10 is a diagram of a structure of an electronic element of a power module according to an embodiment of this application;
FIG. 11a is a diagram of a partial cross-sectional structure of a power module according to an embodiment of this application;
FIG. 11b is a diagram of a partial cross-sectional structure of a power module according to an embodiment of this application;
FIG. 12 is a diagram of a partial cross-sectional structure of a power module according to an embodiment of this application;
FIG. 13a is a diagram of a structure of a conductive structural member of a power module according to an embodiment of this application;
FIG. 13b is a diagram of a structure of a conductive structural member of a power module according to an embodiment of this application;
FIG. 14a is a diagram of a structure of an interconnection component of a power module according to an embodiment of this application;
FIG. 14b is a diagram of a structure of an interconnection component of a power module according to an embodiment of this application;
FIG. 14c is an exploded view of an interconnection component of a power module according to an embodiment of this application;
FIG. 15a is a diagram of a structure of a conductive sheet of a power module according to an embodiment of this application;
FIG. 15b is a diagram of a partial structure of a power module according to an embodiment of this application;
FIG. 16a is a diagram of a structure of a conductive sheet of a power module according to an embodiment of this application;
FIG. 16b is a diagram of a partial structure of a power module according to an embodiment of this application; and
FIG. 17 is a diagram of a partial structure of a power module according to an embodiment of this application.

### Reference numerals:

1000: powertrain; 2000: vehicle body; 3000: wheels; 4000: power battery;
100: motor control unit; 200: motor;
10: power module; 20: circuit board; 30: heat sink;
1: substrate; 11: insulation substrate; 12: first metal layer; 121, 121m, and 121n: metal sublayer; 1211: first metal sublayer; 1212: second metal sublayer; 1213: third metal sublayer; 13: second metal layer; 2, 2m, and 2n: electronic element; 2a: first electronic element; 2b: second electronic element; 2ma and 2na: first-type electronic element; 2mb and 2nb: second-type electronic element; 21: first electrode; 22: second electrode; 23: gate bus; 3, 3m, and 3n: interconnection component; 31: conductive sheet; 311: connection part; 312: interconnection part; 313: pin part; 32, 32a, 32b, 32m, and 32n: conductive structural member; 321: bottom plate; 3211: bottom sub-plate; 3212: connection bottom plate; 322: top plate; 3221: top sub-plate; 323: side plate; 4: connector; 5: connection terminal; 6: plastic packaging body;
C: through slot; E: slot opening; K: notch; G: gap; M: connection surface; P: protrusion part; S: locking hole; Q: through hole; R1: connection segment; R2: bulging segment; and U1 and U2: opening.

### DESCRIPTION OF EMBODIMENTS

A power module may convert and manage electric energy, and is widely used in fields such as photovoltaics, energy storage, and electric vehicles. Applications such as a motor control unit and an industrial frequency converter of an electric vehicle impose higher requirements on output power and integration of the power module. Currently, a power module of single-sided plastic packaging with direct cooling welding has good performance in insulation performance and heat dissipation, and therefore attracts attention. A chip of the single-sided plastic-packaged power module is disposed on a substrate, and a side that is of the chip and that faces away from the substrate is configured to implement circuit interconnection. In a chip interconnection technology of the module of single-sided direct cooling plastic packaging in the conventional technology, costs of a die top system (DTS) in which copper wires (Cu wires) are used are high, through-current effect and reliability of aluminum wires (Al wires) are limited, corners of wire bonding in using ribbons affect a component layout, and a large region for a pad needs to be reserved for copper bonding wires (Cu clip). For some power modules with a large chip area, interconnection layout space of chips is smaller, and impact of a large soldering area on stress of the module needs to be considered.

In view of this, embodiments of this application provide a power module and a power conversion device. The power module implements circuit interconnection by using space on a side that is of an electronic element and that faces away from a substrate, and interconnection stress is reduced by connecting a conductive sheet to a plurality of conductive structural members, so that strength and performance of the module can be improved.

To make objectives, technical solutions, and advantages of this application clearer, the following further describes this application in detail with reference to accompanying drawings.

Terms used in the following embodiments are merely intended to describe specific embodiments, but are not intended to limit this application. Terms "one", "a", "the", "the foregoing", "this", and "the one" of singular forms used in this specification and the appended claims of this application are also intended to include an expression like "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "have", and their variants all mean "include but are not limited to", unless otherwise specifically emphasized in another manner.

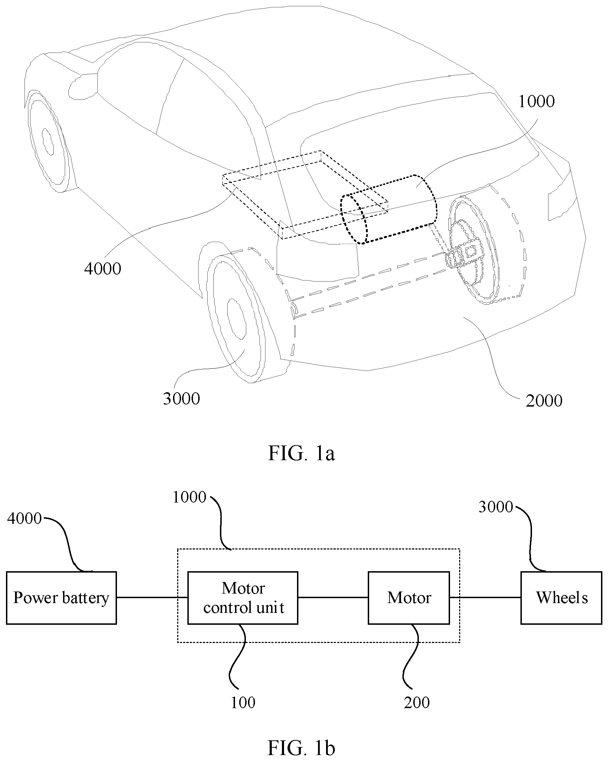

FIG. 1a shows an example of a structure of an electric vehicle according to an embodiment of this application. In this embodiment of this application, the electric vehicle is a wheeled device driven or towed by a power apparatus. In an implementation, the electric vehicle includes a special operation vehicle like a passenger vehicle, a commercial vehicle, an engineering rescue vehicle, a sprinkler, a suction sewage truck, a cement mixer, a crane, or a medical vehicle. For example, the electric vehicle includes a pure electric vehicle (PEV/BEV), a hybrid electric vehicle (HEV), a range extended electric vehicle (REEV), a plug-in hybrid electric vehicle (PHEV), and the like.

As shown in FIG. 1a, the electric vehicle includes a power battery 4000, wheels 3000, a vehicle body 2000, and a powertrain 1000. The powertrain 1000, the power battery 4000, and the wheels 3000 are assembled on the vehicle body 2000.

As shown in FIG. 1b, the powertrain 1000 includes a motor control unit 100 and a motor 200. The motor control unit 100 is configured to receive a direct current of the power battery 4000, and is configured to output an alternating current to the motor 200. The motor 200 is configured to receive the alternating current output by the motor control unit 100, and is configured to drive the wheels 3000 of the electric vehicle. In an embodiment, the powertrain 1000 integrates the motor 200 and the motor control unit 100 into one housing, so that integration of the powertrain 1000 can be increased, and a volume and costs can be reduced. This helps implement a lightweight design of the powertrain 1000 and improve power density.

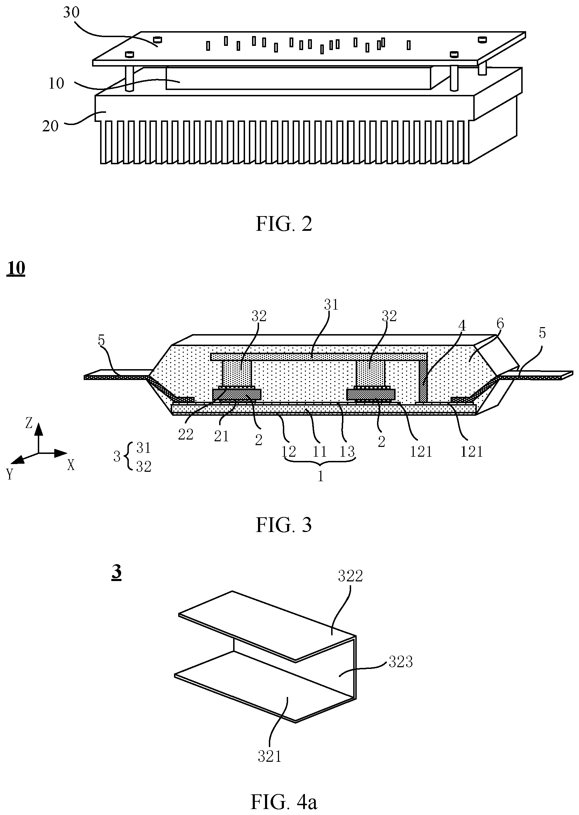

FIG. 2 is a diagram of a structure of a power conversion device according to an embodiment of this application. The motor control unit 100 is a specific implementation of the power conversion device. As shown in FIG. 2, the power conversion device includes a power module 10, a circuit board 20, and a heat sink 30. The power module 10 is electrically connected to the circuit board 20, and the heat sink 30 is in thermally conductive contact with the power module 10, to dissipate heat of the power module 10. In this application, the circuit board 20 may be, for example, a printed circuit board (PCB). The power module 10 may include a plurality of ports, for example, input positive and negative ports, output positive and negative ports, and power supply positive and negative ports. These ports are separately electrically connected to the circuit board 20 via pins, so that the circuit board 20 provides functions such as current or voltage input, current or voltage output, and power supply for the power module 10. The heat sink 30 may use a heat dissipation manner like air cooling, water cooling, or the like, which is not limited in this application. The circuit board 20 is a board-level structure configured to dispose the power module 10, another chip package structure, and the like.

In an embodiment, the heat sink 30 and the power module 10 may be connected through a thermal interface layer. The thermal interface layer can eliminate a gap between the power module 10 and the heat sink 30, increase a heat exchange channel, and improve heat exchange efficiency. The power module 10 may also be referred to as a power module or a power semiconductor module.

FIG. 3 shows a structure of the power module 10 according to an embodiment of this application. As shown in FIG. 3, the power module 10 includes a substrate 1, at least one group of electronic elements 2, and at least one interconnection component 3. Each electronic element 2 is disposed on the substrate 1. Each group of electronic elements 2 includes a plurality of electronic elements 2, each interconnection component 3 is disposed on a side that is of a group of electronic elements 2 and that faces away from the substrate 1, and one interconnection component 3 is configured to connect to one group of electronic elements 2. Between a group of electronic elements 2 and a corresponding interconnection component 3, one electrode of each electronic element 2 is connected to the substrate 1, and the other electrode is connected to the interconnection component 3, so that interconnection between the group of electronic elements 2 can be simplified.

In a structure example, each electronic element 2 includes a first electrode 21 and a second electrode 22. The first electrode 21 and the second electrode 22 are respectively disposed on a surface that is of the electronic element 2 and that faces the substrate 1 and a surface that is of the electronic element 2 and that faces the interconnection component 3. The first electrode 21 and the second electrode 22 are respectively used for current input and output. Each electronic element 2 is connected to the substrate 1 via the first electrode 21, and the electronic element 2 is connected to the interconnection component 3 via the second electrode 22, to implement a parallel connection between a same group of electronic elements 2.

Each interconnection component 3 includes a conductive sheet 31 and a plurality of conductive structural members 32. The conductive sheet 31 and each conductive structural member 32 are both made of metal or another material with good conductivity, and are configured to implement circuit interconnection on the side that is of the plurality of electronic elements 2 and that faces away from the substrate 1. In some embodiments, both the conductive sheet 31 and the conductive structural member 32 are copper, and the copper has good conductivity and good ductility. Certainly, the conductive sheet 31 and the conductive structural member 32 may alternatively be made of other metal or another material with good conductivity, and the conductive sheet 31 and the conductive structural member 32 may be made of a same material or different materials.

The conductive sheet 31 is a continuous and thin sheet. The conductive sheet 31 is in surface contact with each conductive structural member 32, and a contact surface between the conductive sheet 31 and each conductive structural member 32 is approximately parallel to the substrate 1, so that a good electrical connection can be ensured, and a size of the module in a direction perpendicular to the substrate 1 can be reduced.

In a direction perpendicular to a thickness of the substrate 1, between a group of electronic elements 2 and a corresponding interconnection component 3, the conductive sheet 31 is spaced apart on a side of the plurality of electronic elements 2, and there is a gap between a surface that is of the conductive sheet 31 and that faces the substrate 1 and the surface that is of each electronic element 2 and that faces away from the substrate 1. In a same group of electronic elements 2, each electronic element 2 may be connected to the conductive sheet 31 via one or more conductive structural members 32, and second electrodes 22 on the side that is of the plurality of electronic elements 2 and that faces away from the substrate 1 may be converged to the conductive sheet 31 via conductive structural members 32 respectively connected to the second electrodes 22.

In the power module 10, each electronic element 2 in the group of electronic elements 2 is connected to the interconnection component 3, and the interconnection component 3 is disposed on the side that is of the plurality of electronic elements 2 and that faces away from the substrate 1. In other words, circuit interconnection can be implemented by using space on the side that is of the plurality of electronic elements 2 and that faces away from the substrate 1, to save layout space on a surface of the substrate 1, and avoid occupying large space of the substrate 1 caused by separately routing, on the side that is of the plurality of electronic elements 2 and that faces away from the substrate 1, the second electrodes 22 for connection. The interconnection component 3 is formed by connecting the conductive sheet 31 to the plurality of conductive structural members 32. Each electronic element 2 may be connected to the conductive sheet 31 via the one or more corresponding conductive structural members 32, so that a circuit connection is more reliable. Each electronic element 2 is connected to the one or more corresponding conductive structural members 32, and different electronic elements 2 are connected to different conductive structural members 32, so that stress generated by connecting the interconnection component 3 to the plurality of electronic elements 2 can be reduced, and a risk of stress concentration generated by the electronic elements 2 can be reduced, thereby improving structural stability and reliability of the electronic element 2. In addition, reducing the stress generated by connecting the interconnection component 3 to the plurality of electronic elements 2 can also reduce stress transferred to the substrate 1, improve connection stability and reliability between the electronic element 2 and the substrate 1, and reduce a risk of a crack caused by the stress applied to the substrate 1. In this way, structural stability and reliability of the entire module are improved.

The plurality of electronic elements 2 included in the power module 10 include an active component like a chip, or may include a passive component like a capacitor, an inductor, or a resistor. A person skilled in the art can select a type and a quantity of electronic elements 2 based on an actual requirement. This is not limited in this application.

In some embodiments, the electronic element 2 is an electronic component having a power conversion function: a high-power transistor, a thyristor, a bidirectional thyristor, a metal-oxide-semiconductor field-effect transistor (MOSFET), an insulated gate bipolar transistor (IGBT), a diode, a silicon controlled rectifier (SCR), SiC, GaN, or the like. A connection manner of the plurality of electronic elements 2 is not limited. The components may be connected in series or in parallel to form a functional circuit, or the components may be independent monomers. In this way, a quantity of components can be effectively reduced, and a connection manner using copper wires required for discrete components on the circuit board can be reduced, and a size design of the circuit board is optimized, to reduce a volume of the power component. A topology structure of the plurality of electronic elements 2 may be a single tube, a half bridge, an H bridge, a three-phase full bridge, a three level, or the like.

In some embodiments, the substrate 1 may be a substrate fabricated by using a direct bonded copper (DBC) process, and the electronic element 2 may be connected to a copper layer of the substrate 1. The direct bonded copper process is a process in which a single side or double sides of a ceramic substrate is/are clad with copper, and the copper and a ceramic layer are bonded together at a high temperature. Alternatively, the substrate 1 may be fabricated by using a direct plate copper (DPC) process. The direct plate copper process is a manner in which a ceramic substrate is plated with a copper layer through vacuum sputtering, and then a development process is used to manufacture electrical circuits. The substrate 1 may alternatively be fabricated by using an active metal bonding (AMB) process, and is specifically a manner in which high-temperature metallurgical bonding of aluminum nitride and oxygen-free copper is implemented by relying on active brazing filler metal. It may be understood that, in this embodiment of this application, the substrate 1 is not limited to a copper-clad ceramic substrate. The substrate 1 may alternatively be a copper-clad metal substrate or the like. In the copper-clad metal substrate, metal, for example, aluminum, copper, iron, or molybdenum, is used as a substrate, a thermally conductive insulation layer is covered on the substrate, and then a copper layer is covered on a surface of a side that is of the thermally conductive insulation layer and that faces away from the metal substrate. Certainly, the metal layer of the substrate 1 is not limited to the copper layer, and may alternatively be another metal layer like a gold layer.

In the example in FIG. 3, a double-sided copper-clad substrate 1 is provided. The substrate 1 includes the insulation substrate 11, a first metal layer 12, and a second metal layer 13. The first metal layer 12 and the second metal layer 13 are respectively disposed on two surfaces of the insulation substrate 11. The first metal layer 12 and the second metal layer 13 each may be a copper layer. In an example, the plurality of electronic elements 2 included in the power module 10 are disposed on a surface that is of the first metal layer 12 and that faces away from the insulation substrate 11.

Still refer to FIG. 3. The first metal layer 12 includes different metal sublayers 121 that are isolated from each other. Between a group of electronic elements 2 and a connected interconnection component 3, each electronic element 2 is disposed at a same metal sublayer 121, a side that is of each electronic element 2 and that faces away from the metal sublayer 121 is connected to one or more conductive structural members 32, and the conductive sheet 31 is connected to each conductive structural member 32. The conductive sheet 31 is further connected to another metal sublayer 121 via a connector 4, so that the group of electronic elements 2 can be electrically connected to form a current loop. Compared with that in a technical solution in which circuits on the side that is of each electronic element 2 and that faces away from the substrate 1 are separately connected to the substrate 1 for interconnection, in the group of electronic elements 2, circuit interconnection on the side that is of the plurality of electronic elements 2 and that faces away from the substrate 1 only needs to be implemented via the connector 4, so that the layout space of the substrate 1 can be saved. The connector 4 is made of a conductive material with better conductivity, and can implement good circuit connection effect.

In some embodiments, as shown in FIG. 3, the power module 10 further includes a plurality of connection terminals 5, the plurality of connection terminals 5 are separately disposed at the first metal layer 12, and each connection terminal 5 is configured to connect the power module 10 to an external circuit. In an example, one or more of the plurality of connection terminals 5 are used for circuit input, and the other one or more of the plurality of connection terminals 5 are used for circuit output.

In some embodiments, as shown in FIG. 3, the power module 10 further includes a package body 6. The package body 6 packages structures such as the substrate 1, the plurality of electronic elements 2, and the interconnection component 3 into a whole. One end of each connection terminal 5 is packaged in the package body 6, and the other end extends out of the package body 6. The second metal layer 13 of the substrate 1 is exposed outside the package body, the second metal layer 13 may be connected to a heat dissipation apparatus like a heat sink, and heat generated by the electronic element 2 during operation may be transferred to the second metal layer 13 through the first metal layer 12 and the insulation substrate 11. The second metal layer 13 may implement heat dissipation through heat exchange with an external environment or the heat sink.

For ease of description, a three-dimensional coordinate system is established based on the power module 10, and includes a first direction X, a second direction Y, and a third direction Z. Two of the first direction X, the second direction Y, and the third direction Z are perpendicular to each other. The third direction Z is a thickness direction of the substrate 1, and the third direction Z is perpendicular to the substrate 1. The first direction X and the second direction Y are two directions perpendicular to the third direction Z, and the first direction X and the second direction Y are perpendicular to each other. For ease of understanding, an end that is of the power module 10 and that is used for circuit input is opposite to an end that is of the power module 10 and that is used for circuit output in the first direction X.

The following further describes, with reference to a specific implementation, an example of a structure of the interconnection component 3 of the power module 10 provided in this embodiment of this application.

FIG. 4a shows a structure of a conductive structural member 32 in the interconnection component 3 of the power module 10 according to an embodiment of this application. As shown in FIG. 4a, the conductive structural member 32 includes a bottom plate 321, a top plate 322, and at least one side plate 323. Between a conductive structural member 32 and a correspondingly connected electronic element 2, the bottom plate 321 is connected to the surface that is of the electronic element 2 and that faces away from the substrate 1, the top plate 322 is connected to the conductive sheet 31, and each side plate 323 is connected between the bottom plate 321 and the top plate 322. The conductive structural member 32 formed by connecting the bottom plate 321, the top plate 322, and the at least one side plate 323 occupies space in the direction perpendicular to the thickness of the substrate 1, and connects, to the conductive sheet 31, the circuit on the surface that is of the electronic element 2 and that faces away from the substrate 1.

The bottom plate 321 is a continuous and thin plate, the top plate 322 is also a continuous and thin plate, and in a direction in which the side plate 323 connects the top plate 322 to the bottom plate 321, there is a gap between the bottom plate 321 and the top plate 322. The bottom plate 321 is connected to the top plate 322 via the at least one side plate 323, so that the conductive structural member 32 is of a three-dimensional structure, which is specifically similar to a frame structure. A cross-sectional area of a joint between the side plate 323 and the top plate 322 is usually less than a surface that is of the top plate 322 and that faces the bottom plate 321, and a cross-sectional area of a joint between the side plate 323 and the bottom plate 321 is usually less than a surface that is of the bottom plate 321 and that faces the top plate 322, so that the bottom plate 321 and the top plate 322 may have a specific deformation amount when being subject to force, and further, a structure of the conductive structural member 32 has a specific deformation amount. The deformability may also be considered as flexibility of the conductive structural member 32. When the conductive structural member 32 is connected to the electronic element 2, stress generated during the connection may be absorbed through structural deformation of the conductive structural member 32, to ensure connection reliability and connection strength between the conductive structural member 32 and the electronic element 2.

In addition, the conductive structural member 32 and the electronic element 2 are usually made of different materials, and different thermal expansion coefficients of different materials affect the connection between the conductive structural member 32 and the electronic element 2. The conductive structural member 32 may reduce, through the structural deformation of the conductive structural member 32, deformation of a connection interface caused by the thermal expansion coefficients of different materials. A difference in the thermal expansion coefficients between the conductive structural member 32 and the electronic element 2 has small impact, and the conductive structural member 32 may select more types of materials. In an embodiment, the side plate 323 is also a continuous and thin plate, and a size of the side plate 323 in the direction in which the top plate 322 is connected to the bottom plate 321 is greater than a thickness of the side plate 323, so that the deformability of the conductive structural member 32 can be further enhanced.

As shown in FIG. 4a, in an embodiment, the bottom plate 321 and the top plate 322 are disposed opposite to each other, there is a specific gap between the bottom plate 321 and the top plate 322, and the at least one side plate 323 provides support for a position between the top plate 322 and the bottom plate 321. The conductive structural member 32 is of the three-dimensional structure. Using a thickness direction of the side plate 323 as a reference, an extension direction of the bottom plate 321 is the same as an extension direction of the top plate 322, and the bottom plate 321, the side plate 323, and the top plate 322 are sequentially connected to form a concave frame structure. In an arrangement direction of the bottom plate 321 and the top plate 322, orthographic projection of the top plate 322 on the bottom plate 321 at least partially overlaps the bottom plate 321, and both the top plate 322 and the bottom plate 321 are connected to a same side in the thickness direction of the side plate 323. When the bottom plate 321 and the top plate 322 of the conductive structural member 32 are respectively connected to other structures, there is specific flexibility between the bottom plate 321 and the side plate 323 and between the top plate 322 and the side plate 323, and specific structural deformation may be generated based on applied force, thereby improving connection reliability.

In some embodiments, the top plate 322 and the bottom plate 321 are parallel to each other, and the side plate 323 is separately perpendicular to the top plate 322 and the bottom plate 321. Alternatively, the side plate 323 may be inclined relative to the top plate 322 and the bottom plate 321, and the side plate 323 is disposed at an included angle with the top plate 322 and the bottom plate 321. Certainly, the side plate 323 may alternatively have another structural form, provided that the side plate 323 can connect the top plate 322 to the bottom plate 321 and keep the gap between the top plate 322 and the bottom plate 321, to ensure that the conductive structural member 32 is deformable to some extent.

In a structure example, the side plate 323 is perpendicular to or approximately perpendicular to the bottom plate 321. An included angle between the side plate 323 and the bottom plate 321 may be 90±5°.

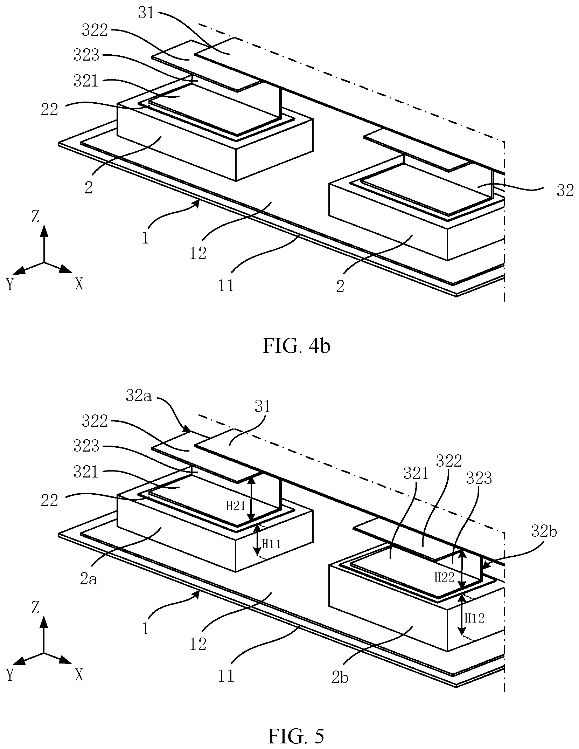

FIG. 4b shows an example of a partial structure of the power module 10. As shown in FIG. 4b, the power module 10 includes two electronic elements 2 connected in parallel, and the two electronic elements 2 are separately connected, via two conductive structural members 32 shown in FIG. 4a, to one conductive sheet 31. Specifically, each electronic element 2 is disposed at the first metal layer 12 of the substrate 1, and the two electronic elements 2 are spaced apart in the first direction X. The first electrode 21 on a side that is of each electronic element 2 and that faces the substrate 1 is connected to the first metal layer 12, and the second electrode 22 on a surface that is of each electronic element 2 and that faces away from the substrate 1 is connected to the bottom plate 321 of the conductive structural member 32. The first electrode 21 is blocked and not shown. The top plates 322 of the two conductive structural members 32 are simultaneously connected to one conductive sheet 31. In a direction perpendicular to the substrate 1, namely, in the third direction Z, orthographic projection of the conductive sheet 31 on the substrate 1 at least partially overlaps orthographic projection of each top plate 322 on the substrate 1, and the conductive sheet 31 is in contact with the top plate 322 of each conductive structural member 32, to implement circuit convergence with the plurality of electronic elements 2. For each electronic element 2, the first electrode 21 is connected to the first metal layer 12 of the substrate 1, the second electrode 22 is connected to the conductive sheet 31 via the conductive structural member 32, and circuit parallel connection is implemented between the plurality of electronic elements 2.

As shown in FIG. 4b, the top plate 322 and the bottom plate 321 of each conductive structural member 32 are opposite to each other in the third direction Z, so that a size of the conductive structural member 32 in a direction parallel to the substrate 1 can be reduced, thereby facilitating miniaturization of the module.

The bottom plate 321 is connected to the second electrode 22 of the electronic element 2 in a surface contact manner, so that stability and reliability of an electrical connection between the bottom plate 321 and the second electrode 22 can be ensured. Considering internal stress generated by the connection between the second electrode 22 and the bottom plate 321, orthographic projection of each bottom plate 321 on a corresponding electronic element 2 falls within a range of the second electrode 22, to reduce impact of connection stress on the electronic element 2 while ensuring a reliable electrical connection.

In some embodiments, the bottom plate 321 is connected to the second electrode 22 of the electronic element 2 through laser welding or reflow soldering. The bottom plate 321 is disposed at a specific distance from an edge of the second electrode 22 of the electronic element 2, so that solder spread can be allowed in a soldering process. This helps improve feasibility of a soldering operation.

In an embodiment, in the third direction Z, between each electronic element 2 and the corresponding conductive structural member 32, orthographic projection of the bottom plate 321 of the conductive structural member 32 on the electronic element 2 falls within a range of the first electrode 21. The top plate 322 of each conductive structural member 32 is connected to the conductive sheet 31 in a surface contact manner, so that stability and reliability of an electrical connection between the top plate 322 and the conductive sheet 31 can be ensured. Connections between the top plates 322 of the conductive structural members 32 and the conductive sheet 31 are independent of each other, so that connection correlation between the plurality of conductive structural members 32 and the conductive sheet 31 can be reduced, and connection flexibility and feasibility can be improved. Compared with that in an integrated conductive structure, stress of the connections between the plurality of conductive structural members 32 and the conductive sheet 31 is smaller during the connections to the plurality of electronic elements 2. This helps improve reliability of the module. The connection between each electronic element 2 and the conductive sheet 31 is implemented via the conductive structural member 32, facilitating subsequent structural maintenance.

In a partial structure of the power module 10 shown in FIG. 5, two electronic elements 2 connected in parallel are separately connected to a same conductive sheet 31 via two conductive structural members 32. The two electronic elements 2 are a first electronic element 2a and a second electronic element 2b respectively. The first electronic element 2a is connected to the conductive sheet 31 via a conductive structural member 32a, the second electronic element 2b is connected to the conductive sheet 31 via a conductive structural member 32b, and a surface that is of the conductive structural member 32a and that faces away from the first electronic element 2a is aligned with or coplanar with a surface that is of the conductive structural member 32b and that faces away from the second electronic element 2b. For example, in the third direction Z, distances between the conductive sheet 31 and the first metal layer 12 of the substrate 1 are the same in positions in which the two electronic elements 2 are disposed, and a height H11 of the first electronic element 2a is less than a height H12 of the second electronic element 2b. In this case, a height H21 of the conductive structural member 32a between the first electronic element 2a and the conductive sheet 31 is greater than a height H22 of the conductive structural member 32b between the second electronic element 2b and the conductive sheet 31, and a sum of H11 and H21 is equal to a sum of H12 and H22.

With reference to the example in FIG. 5, for the power module 10 including a plurality of types of electronic elements 2, when different types of electronic elements 2 are connected in parallel to the same conductive sheet 31, conductive structural members 32 of different heights may be selected based on heights of different electronic elements 2, to compensate for a height difference between different electronic elements 2. Circuit connections between different electronic elements 2 are more feasible and more reliable.

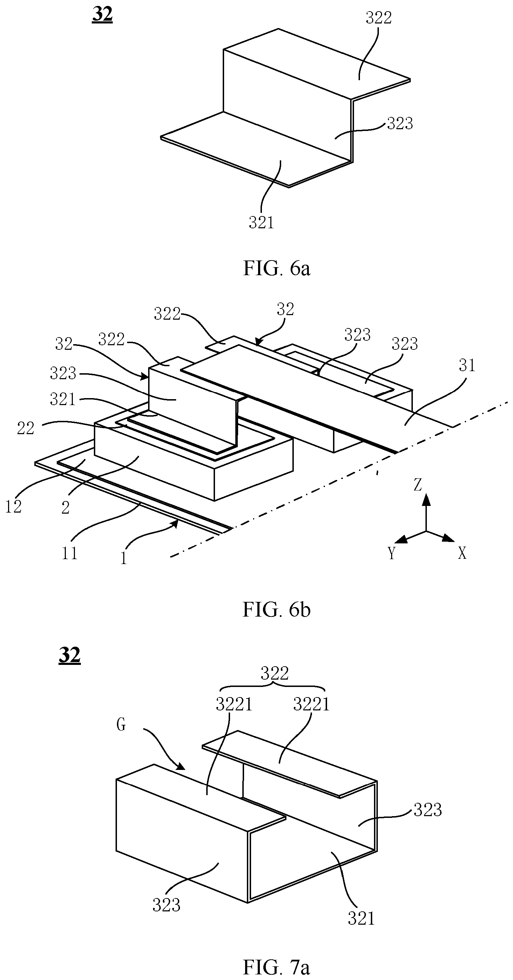

FIG. 6a shows an example of another structure of the conductive structural member 32. A difference from the conductive structural member 32 shown in FIG. 4a lies in that the conductive structural member 32 is of a three-dimensional structure with two bends with the thickness direction of the side plate 323 as a reference and extension directions of the top plate 322 and the bottom plate 321 being opposite. In an arrangement direction of the bottom plate 321 and the top plate 322, the top plate 322 and the bottom plate 321 are respectively connected to two sides in the thickness direction of the side plate 323. When the bottom plate 321 and the top plate 322 of the conductive structural member 32 are respectively connected to other structures, there is specific flexibility between the bottom plate 321 and the side plate 323 and between the top plate 322 and the side plate 323, and specific structural deformation is acceptable based on a force applying requirement, thereby improving connection reliability. Certainly, in some embodiments, the side plate 323 may alternatively be designed to be inclined relative to the bottom plate 321 and the top plate 322, provided that the top plate 322 can be connected to the bottom plate 321 and there is the gap between the top plate 322 and the bottom plate 321.

FIG. 6b shows an example of a partial structure of the power module 10. As shown in FIG. 6b, the power module 10 includes two electronic elements 2 connected in parallel, and the two electronic elements 2 are separately connected, via two conductive structural members 32 shown in FIG.6a, to one conductive sheet 31. One of the electronic elements 2 is used as an example. The second electrode 22 of the electronic element 2 is connected to the bottom plate 321 of the conductive structural member 32, and the top plate 322 of the conductive structural member 32 is connected to the conductive sheet 31.

In some embodiments, in the third direction Z, the orthographic projection of the conductive sheet 31 on the substrate 1 at least partially overlaps the top plate 322, to implement the reliable electrical connection between the conductive sheet 31 and the top plate 322. For example, the two electronic elements 2 are spaced apart in the second direction Y, and the conductive sheet 31 may be connected to the two electronic elements 2 in the second direction Y. Specifically, when the conductive structural member 32 connected between the electronic element 2 and the conductive sheet 31 is disposed, the two conductive structural members 32 are spaced apart in the second direction Y to be simultaneously connected to the conductive sheet 31. Between the two conductive structural members 32, the top plates 322 of the two conductive structural members 32 are opposite to each other in the second direction Y, and the bottom plates 321 of the two conductive structural members 32 are away from each other. When the top plates 322 of the two conductive structural members 32 are connected to the conductive sheet 31, with connection areas between the top plates 322 and the conductive sheet 31 being the same, a size of the conductive sheet 31 in the second direction Y can be reduced. This helps further save structural layout space.

Between a group of electronic elements 2 connected in parallel, heights of electronic elements 2 in the third direction Z may be different. When the distance between the conductive sheet 31 and the substrate 1 in the third direction Z remains unchanged, the electronic elements 2 at different heights may be connected to conductive structural members 32 at different heights. This is applicable to a case in which different types of electronic elements 2 are connected to one conductive sheet 31.

FIG. 7a to FIG. 7c respectively show examples of three types of conductive structural members 32 of different structures. The top plates 322 of the conductive structural members 32 each include two top sub-plates 3221, and the two top sub-plates 3221 are spaced apart in a direction parallel to the bottom plate 321. The two top sub-plates 3221 are not in contact with each other and form a gap G. The two top sub-plates 3221 are respectively connected to two opposite sides of the bottom plate 321 via two side plates 323, the two side plates 323 are opposite to each other in an arrangement direction of the two top sub-plates 3221, and the entire conductive structural member 32 is of a half-enclosed structure in which the two side plates 323 are opposite to each other. The two top sub-plates 3221 are both configured to connect to the conductive sheet 31. In this case, there are two positions in which the conductive sheet 31 is connected to the conductive structural member 32, and the two positions are spaced apart in a direction in which the two top sub-plates 3221 are opposite to each other. Therefore, there are two opposite connection positions between the conductive sheet 31 and the conductive structural member 32, more balanced force is applied, and a connection is more reliable.

As shown in FIG. 7a, the two top sub-plates 3221 extend toward each other. Using the two side plates 323 as a reference, the two top sub-plates 3221 are respectively connected to two opposite surfaces of the two side plates 323. In the arrangement direction of the two top sub-plates 3221, a width of the gap G between the two top sub-plates 3221 is less than a distance between sides on which the two side plates 323 are connected to the top sub-plates 3221, and a sum of widths of the two top sub-plates 3221 and the width of the gap G is the distance between the sides on which the two side plates 323 are connected to the top sub-plates 3221. When the two top sub-plates 3221 are connected to the conductive sheet 31, force transferred by the two top sub-plates 3221 to the side plates 323 may be basically the same, so that stability of the conductive structural member 32 under the force can be improved.

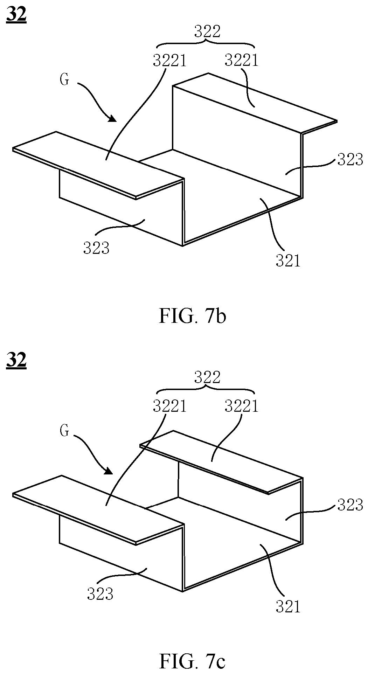

As shown in FIG. 7b, the two top sub-plates 3221 extend away from each other. Using the two side plates 323 as a reference, the two top sub-plates 3221 are respectively connected to two surfaces that are of the two side plates 323 and that are away from each other. In the arrangement direction of the two top sub-plates 3221, the width of the gap G between the two top sub-plates 3221 is greater than or equal to the distance between the sides on which the two side plates 323 are connected to the top sub-plates 3221. When the two top sub-plates 3221 are connected to the conductive sheet 31, the force transferred by the two top sub-plates 3221 to the side plates 323 may be basically the same, so that the stability of the conductive structural member 32 under the force can be improved.

As shown in FIG. 7c, extension directions of the two top sub-plates 3221 are opposite. Using the two side plates 323 as a reference, one top sub-plate 3221 is connected to a surface that is of one corresponding side plate 323 and that faces the other side plate 323, and the other top sub-plate 3221 is connected to a surface that is of the corresponding other side plate 323 and that faces away from the one side plate 323. In the arrangement direction of the two top sub-plates 3221, the width of the gap G between the two top sub-plates 3221 is less than the distance between the sides on which the two side plates 323 are connected to the top sub-plates 3221, and a sum of a width of one top sub-plate 3221 located between the two side plates 323 and the width of the gap G is the distance between the sides on which the two side plates 323 are connected to the top sub-plates 3221. The two top sub-plates 3221 have better flexibility when being connected to the conductive sheet 31.

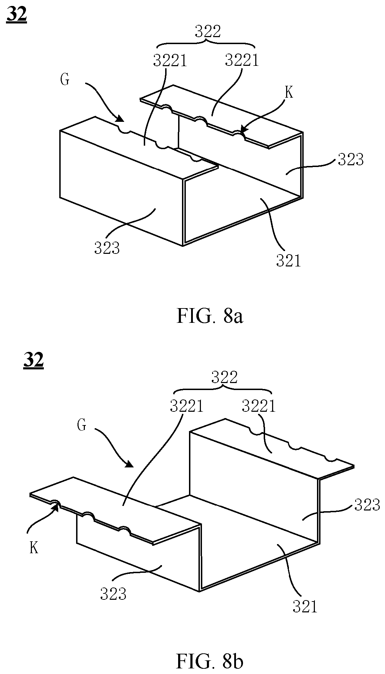

Based on the conductive structural members 32 shown in FIG. 7a to FIG. 7c, as shown in FIG. 8a to FIG. 8c, in some embodiments, in the arrangement direction of the two top sub-plates 3221, an edge that is of each top sub-plate 3221 and that is away from a connected side plate 323 includes a plurality of notches K that are spaced apart, and each notch K is recessed inward in a direction in which the top sub-plate 3221 is connected to the side plate 323, so that the edge that is of the top sub-plate 3221 and that is away from the side plate 323 is in an irregular shape. In a plastic packaging process of the power module 10, the notch K may strengthen bonding strength between the top sub-plate 3221 and a plastic packaging material.

With reference to FIG. 7a to FIG. 7c and FIG. 8a to FIG. 8c, the conductive structural member 32 is a metal part of an integrated structure, and may be specifically made of a copper material. In specific fabrication, the bottom plate 321, the side plate 323, and the top plate 322 of the conductive structural member 32 may be formed by using processes such as sheet metal bending and stamping.

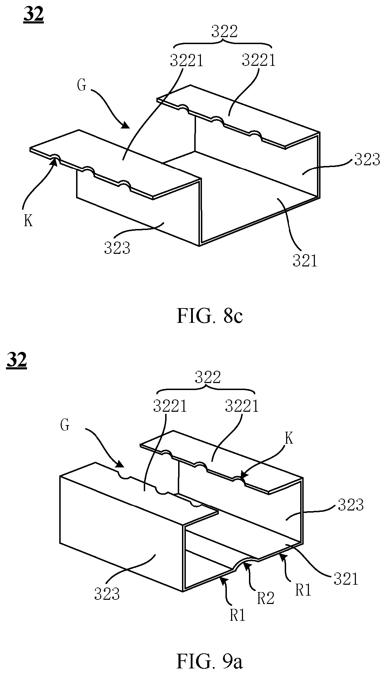

In some embodiments, as shown in FIG. 8c, in the arrangement direction of the two top sub-plates 3221, one notch K of one top sub-plate 3221 is opposite to one notch K of the other top sub-plate 3221. In the plastic packaging process of the power module 10, a melt plastic packaging material can flow between the two top sub-plates 3221 at a balanced flow rate and in a balanced flow state, to optimize bonding between the plastic packaging material and the top sub-plates 3221, and improve structural stability and reliability of the module 10 after the plastic packaging material is cured.

In an embodiment, a surface that is of the bottom plate 321 and that faces away from the top plate 322 includes a groove, and the groove is recessed to a side of the top plate 322 along the bottom plate 321. When the bottom plate 321 of the conductive structural member 32 is connected to the electronic element 2, the bottom plate 321 in a position of the groove is not in contact with the electronic element 2, so that a contact area between the bottom plate 321 and the electronic element 2 can be reduced, thereby reducing the stress generated during the connection. Due to existence of the groove, a surface that is of the bottom plate 321 and that is used to connect to the electronic element 2 includes a plurality of regions, so that the bottom plate 321 can be connected to the electronic element 2 at at least a plurality of points, thereby reducing the stress and improving the connection reliability.

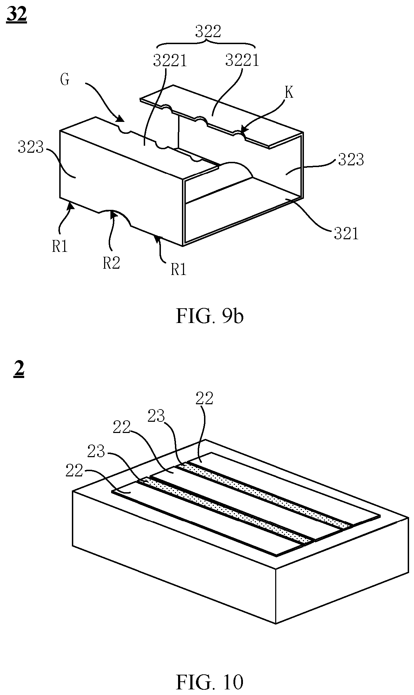

As shown in FIG. 9a and FIG. 9b, in a structure example, the bottom plate 321 includes two connection segments R1 and a bulging segment R2, the bulging segment R2 is connected between the two connection segments R1, each connection segment R1 is configured to connect to the electronic element 2, and the bulging segment R2 bulges in a direction away from the electronic element 2. Based on the structure of the conductive structural member 32, a bulging direction of the bulging segment R2 is the direction in which the bottom plate 321 faces the top plate 322, so that the groove is formed on a surface that is of the bulging segment R2 and that faces away from the top plate 322. Using the surface that is of the bottom plate 321 and that faces away from the top plate 322 as a reference, the surface that is of the bulging segment R2 and that faces away from the top plate 322 is not aligned with a surface that is of the connection segment R1 and that faces away from the top plate 322, and the surface that is of the bulging segment R2 and that faces away from the top plate 322 is recessed relative to the surface that is of the connection segment R1 and that faces away from the top plate 322. When the bottom plate 321 is connected to the electronic element 2, the connection segment R1 is configured to be in contact with the electronic element 2 to implement an electrical connection, and the bulging segment R2 is not in contact with the electronic element 2, so that the contact area between the bottom plate 321 and the electronic element 2 is reduced, the stress generated during the connection can be reduced, and connection reliability and feasibility are improved.

To avoid interference between the bulging segment R2 and the top plate 322, in a direction perpendicular to the bottom plate 321, a height of the bulging segment R2 is less than a height of the side plate 323.

In an embodiment, the bulging segment R2 is in a long strip shape, two ends of the bulging segment R2 extend to two opposite sides of the bottom plate 321, and parts on two sides of the bulging segment R2 form the connection segments R1. The bulging segment R2 separates the connection segments R1 that are of the bottom plate 321 and that are configured to connect to the electronic element 2, and the surface that is of the bottom plate 321 and that is connected to the electronic element 2 may be divided into two regions by the bulging segment R2, so that the bottom plate 321 can be connected to the electronic element 2 in at least two positions, thereby reducing the stress and improving the connection reliability.

During manufacturing of the conductive structural member 32, the bulging segment R2 may be formed through bending, stamping, or the like. For example, a shape of a cross section that is of the bulging segment R2 and that is perpendicular to the extension direction may be an arc, a polyline, a trapezoid, a rectangle, or the like. Certainly, the bulging segment R2 may alternatively have another structure form. The design of the bulging segment R2 may enable a partial region of a surface that is of the bottom plate 321 and that faces the electronic element 2 not to be in contact with the electronic element 2, to reduce the contact area in the connection between the bottom plate 321 and the electronic element 2, and reduce the stress.

In FIG. 9a, the extension direction of the bulging segment R2 is disposed at an included angle with the arrangement direction of the two top sub-plates 3221, and the two ends of the bulging segment R2 respectively extend to the two sides that are of the bottom plate 321 and that are not connected to the side plates 323. In a process of fabricating the conductive structural member 32, formation of the bulging segment R2 is parallel to or approximately parallel to a bending force bearing direction of the side plate 323 relative to the bottom plate 321. This helps improve implementation of a fabrication process of the conductive structural member 32. In an embodiment, in the direction perpendicular to the bottom plate 321, orthographic projection of the bulging segment R2 on the top plate 322 falls within the gap G. When the height of the side plate 323 is small, the bulging segment R2 may be avoided via the gap G.

In FIG. 9b, the extension direction of the bulging segment R2 is perpendicular to the arrangement direction of the two top sub-plates 3221, and the two ends of the bulging segment R2 respectively extend to two sides that are of the bottom plate 321 and that are connected to the side plates 323. The two ends of the bulging segment R2 may change force applied to the two side plates 323 and the bottom plate 321 at joints, and play a role similar to that of a reinforcing rib.

FIG. 10 shows a structure of the electronic element 2. As shown in FIG. 10, the electronic element 2 includes the first electrode 21 and the second electrode 22, and the first electrode 21 and the second electrode 22 are respectively disposed on two opposite surfaces of the electronic element 2. An overall structure of the power module 10 is used as an example. In the third direction Z, namely, the thickness direction of the substrate 1, the first electrode 21 of the electronic element 2 is disposed on a surface facing the substrate 1, and the second electrode 22 is disposed on a surface facing away from the substrate 1.

As shown in FIG. 10, the electronic element 2 further includes a gate bus 23, and the gate bus 23 is configured to lead a gate signal of the electronic element 2. In a structure example, the gate bus 23 and the second electrode 22 are disposed at a same layer, that is, the gate bus 23 and the second electrode 22 are located on a same surface of the electronic element 2. The second electrode 22 of the electronic element 2 is located on the side that is of the electronic element 2 and that faces away from the substrate 1, and the gate bus 23 and the second electrode 22 are spaced from each other to implement electrical insulation. The second electrode 22 is configured to connect to the conductive structural member 32, to implement circuit interconnection on the side that is of the electronic element 2 and that faces away from the substrate 1. Therefore, the conductive structural member 32 needs to avoid the gate bus 23, to prevent gate leakage caused by a short circuit between the conductive structural member 32 and the gate bus 23.

In an embodiment, as shown in FIG. 10, the electronic element 2 includes a plurality of second electrodes 22 and at least one gate bus 23, and each gate bus 23 is arranged between two second electrodes 22. When the plurality of second electrodes 22 of the electronic element 2 are connected to the conductive sheet 31 via one conductive structural member 32, the bottom plate 321 of the conductive structural member 32 needs to avoid the gate bus 23 between the two second electrodes 22.

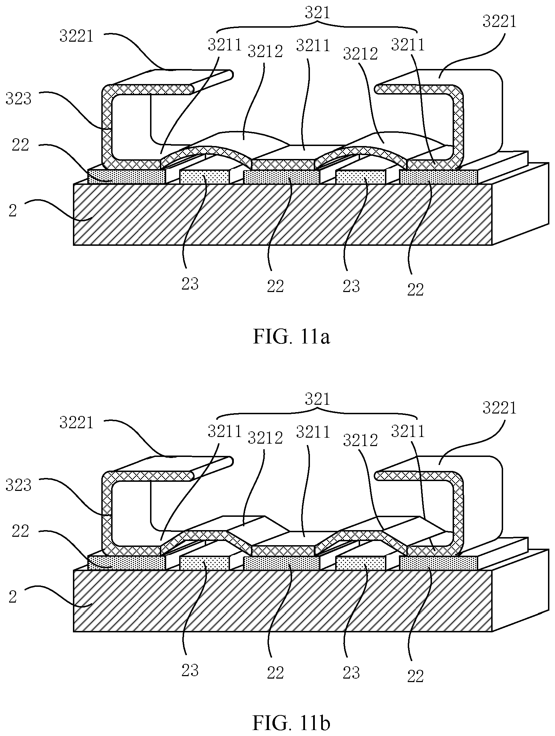

Based on the electronic element 2 shown in FIG. 10, the conductive structural member 32 in the power module 10 provided in this embodiment of this application may be a structure shown in FIG. 11a or FIG. 11b. As shown in FIG. 11a and FIG. 11b, the bottom plate 321 of the conductive structural member 32 includes a plurality of bottom sub-plates 3211, and each bottom sub-plate 3211 is configured to connect to one second electrode 22. In the direction perpendicular to the substrate 1, orthographic projection of each bottom sub-plate 3211 on the electronic element 2 falls within a range of one second electrode 22. This avoids a short circuit between the bottom plate 321 and another structure of the electronic element 2 and improves safety of the module. In an embodiment, the orthographic projection of each bottom sub-plate 3211 on the electronic element 2 is not in contact with any gate bus 23, so that a short-circuit risk between the bottom plate 321 and the gate bus 23 can be avoided.

It should be understood that, when the electronic element 2 does not include the structure of the gate bus 23, the orthographic projection of each bottom sub-plate 3211 on the electronic element 2 falls within the range of the one second electrode 22, to avoid the short circuit between the bottom plate 321 and the another structure of the electronic element 2 and improve the safety of the module while ensuring a good electrical connection.

In an embodiment, a structure in which one gate bus 23 is arranged between two second electrodes 22 is used as an example. In an arrangement direction of the second electrode 22 and the gate bus 23, a distance between two adjacent bottom sub-plates 3211 is greater than or equal to a distance between two second electrodes 22 connected to the two bottom sub-plates 3211, and a distance between a gate bus 23 between the two second electrodes 22 and a bottom sub-plate 3211 on either side is greater than or equal to a distance between the gate bus 23 and a second electrode 22 corresponding to the side. This increases a distance between the gate bus 23 and the bottom sub-plate 3211, and reduces a short-circuit risk between the gate bus 23 and the bottom sub-plate 3211.

Refer to FIG. 11a and FIG. 11b together. An arrangement direction of the plurality of bottom sub-plates 3211 of the bottom plate 321 is the same as the arrangement direction of the second electrode 22 and the gate bus 23, so that the plurality of bottom sub-plates 3211 can be respectively connected to the plurality of second electrodes 22 and avoid the gate bus 23.

In the structures shown in FIG. 11a and FIG. 11b, an arrangement direction of the two top sub-plates 3221 of the conductive structural member 32 is the same as the arrangement direction of the plurality of bottom sub-plates 3211, each top sub-plate 3221 is connected to a corresponding bottom sub-plate 3211 via one side plate 323, and an arrangement direction of the two side plates 323 is the same as the arrangement direction of the plurality of bottom sub-plates 3211. When there are three or more second electrodes 22, two bottom sub-plates 3211 on two sides in the arrangement direction of the plurality of bottom sub-plates 3211 may be respectively connected to two top sub-plate 3221 via the side plates 323, and one or more bottom sub-plates 3211 located in the middle are not connected to the side plate 323. As a result, the second electrodes 22 corresponding to the one or more bottom sub-plates 3211 cannot be electrically connected to the conductive sheet 31 in the circuit. To connect the bottom sub-plate 3211 not directly connected to the side plate 323 to the top plate 322, the bottom plate 321 includes at least two connection bottom plates 3212, and each connection bottom plate 3212 is connected between two bottom sub-plates 3211. In the direction perpendicular to the bottom plate 321, each connection bottom plate 3212 bulges in a direction away from the electronic element 2 to avoid the gate bus 23. Based on the structure of the bottom plate 321 shown in FIG. 11a, any two adjacent bottom sub-plates 3211 are connected via one connection bottom plate 3212, and each connection bottom plate 3212 is connected to the two adjacent bottom sub-plates 3211, so that each bottom sub-plate 3211 may be connected to the top plate 322 via the side plate 323, and further, each second electrode 22 may be connected to the conductive sheet 31 via the conductive structural member 32 to implement circuit interconnection.

FIG. 11a shows an example of a circular arch-shaped connection bottom plate 3212. The connection bottom plate 3212 may alternatively be a trapezoid shown in FIG. 11b. Certainly, the connection bottom plate 3212 may alternatively be in a polyline shape or another arched shape, to avoid the gate bus 23.

With reference to FIG. 11a and FIG. 11b, the plurality of bottom sub-plates 3211 of the bottom plate 321 of the conductive structural member 32 are respectively connected to the plurality of second electrodes 22, so that the gate bus 23 can be avoided, and the short-circuit risk between the bottom plate 321 and the gate bus 23 can be reduced. A connection area that is of the bottom plate 321 and that is used to connect to the electronic element 2 is a contact area between the plurality of bottom sub-plates 3211 and the plurality of second electrodes 22. A connection point between the bottom plate 321 and the electronic element 2 is divided into a plurality of connection points, so that the stress generated by connecting the bottom plate 321 to the electronic element 2 can be reduced, and connection stability can be further improved.

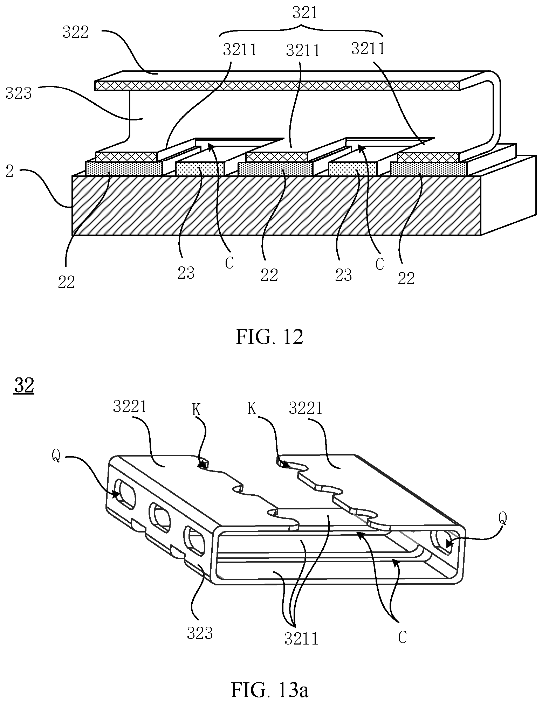

FIG. 12 shows another partial cross-sectional structure in which the conductive structural member 32 is connected to the electronic element 2. As shown in FIG. 12, the bottom plate 321 of the conductive structural member 32 includes a plurality of bottom sub-plates 3211 that are isolated from each other, and each bottom sub-plate 3211 is configured to connect to one second electrode 22. An arrangement direction of the plurality of bottom sub-plates 3211 of the bottom plate 321 is the same as the arrangement direction of the second electrode 22 and the gate bus 23. In the direction perpendicular to the substrate 1, orthographic projection of each bottom sub-plate 3211 on the electronic element 2 falls within a range of the one second electrode 22, and the orthographic projection of each bottom sub-plate 3211 on the electronic element 2 is not in contact with any gate bus 23, to avoid the short-circuit risk between the bottom plate 321 and the gate bus 23.

In the conductive structural member 32 shown in FIG. 12, the side plate 323 configured to connect to the top plate 322 extends in the arrangement direction of the plurality of bottom sub-plates 3211, the side plate 323 is connected to each bottom sub-plate 3211, and each bottom sub-plate 3211 may be connected to the top plate 322 via the side plate 323, so that each second electrode 22 may be electrically connected to the conductive sheet 31 in the circuit to implement electrical interconnection.

Still refer to the conductive structural member 32 shown in FIG. 12. The bottom plate 321 may be divided into the plurality of bottom sub-plates 3211 through slotting, stamping, cutting, or the like. As shown in FIG. 12, a plurality of through slots C are formed at the bottom of the bottom plate 321 through slotting, each through slot C penetrates two surfaces of the bottom plate 321 in a thickness direction of the bottom plate 321, and orthographic projection of each through slot C on the electronic element 2 covers one gate bus 23, for the bottom sub-plate 3211 to avoid the gate bus 23.

FIG. 13a shows a structure of the conductive structural member 32. As shown in FIG. 13a, the top plate 322 of the conductive structural member 32 includes two top sub-plates 3221, and each top sub-plate 3221 is connected to the bottom plate 321 via one side plate 323. The bottom plate 321 includes a plurality of bottom sub-plates 3211, two ends of each bottom sub-plate 3211 are respectively connected to the two side plates 323, and each side plate 323 is connected to the plurality of bottom sub-plates 3211.

In an embodiment, as shown in FIG. 13a, the side plate 323 of the conductive structural member 32 includes a plurality of through holes Q, and each through hole Q penetrates an inner surface and an outer surface of the side plate 323. The inner surface and the outer surface of the side plate 323 are two surfaces of the side plate 323 in a thickness direction. For the two side plates 323, an inner surface and an outer surface of one side plate 323 are respectively a surface that is of the one side plate 323 and that faces the other side plate 323 and a surface that is of the one side plate 323 and that faces away from the other side plate 323. In the plastic packaging process of the power module 10, the melted plastic packaging material may pass through the through hole Q, to improve bonding strength between the plastic packaging material and the side plate 323. The through hole Q may enhance locking effect, thereby improving the reliability and the stability of the module.

Still refer to FIG. 13a. The plurality of bottom sub-plates 3211 of the bottom plate 321 are formed by slotting a part that is of the conductive structural member 32 and that is used to form the bottom plate 321, there is one through slot C between any two adjacent bottom sub-plates 3211, and the through slot C is configured to avoid the gate bus 23 of the electronic element 2. Each through slot C extends in the arrangement direction of the two side plates 323, and an end position of each through slot C is close to the side plate 323. When the through hole Q is disposed on the side plate 323, for the overall structure of the conductive structural member 32, both the through hole Q and the through slot C are hollow structures for structure reduction, and the through hole Q is close to the end position of the through slot C. To ensure structural strength of the conductive structural member 32, in the arrangement direction of the plurality of bottom sub-plates 3211, the plurality of through holes Q on the side plate 323 are spaced apart, and each through hole Q is configured to be located between two through slots C, so that the plurality of through holes Q and the plurality of through slots C are alternately distributed.

In a specific structure, in the direction perpendicular to the bottom plate 321, orthographic projection of each through hole Q on the bottom plate 321 is located between two through slots C, to avoid weak structural performance of the conductive structural member 32 between the through slot C and the through hole Q, improve the structural strength of the conductive structural member 32, and further, ensure reliability of the circuit interconnection.

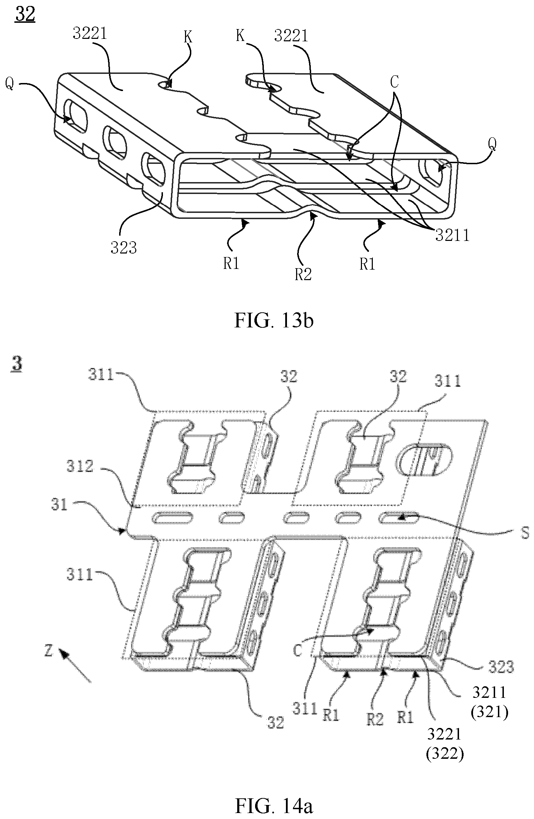

FIG. 13b is a diagram of a structure of the conductive structural member 32 according to an embodiment of this application. As shown in FIG. 13b, the bottom plate 321 of the conductive structural member 32 includes two connection segments R1 and a bulging segment R2 connected between the two connection segments R1. A function of the bulging segment R2 is to reduce the surface that is of the bottom plate 321 and that is used to connect to the electronic element 2, to reduce the contact area between the bottom plate 321 and the electronic element 2, thereby reducing the connection stress between the bottom plate 321 and the electronic element 2. This helps improve the structural stability and reliability of the module.

In an embodiment, the bottom plate 321 includes a plurality of bottom sub-plates 3211 that are spaced apart, each bottom sub-plate 3211 extends in the arrangement direction of the two side plates 323, and a length of the bottom sub-plate 3211 in the arrangement direction of the two side plates 323 is greater than a width in an arrangement direction of the plurality of bottom sub-plates 3211. A connection direction between the bulging segment R2 and the two connection segments R1 is at an included angle with the arrangement direction of the plurality of bottom sub-plates 3211, and the bulging segment R2 may divide each bottom sub-plate 3211 into two parts in a length direction of each bottom sub-plate 3211. Each bottom sub-plate 3211 forms two connection segments R1 in regions on two sides of the bulging segment R2, and each bottom sub-plate 3211 is connected to the electronic element 2 via the two connection segments R1. A surface that is of each bottom sub-plate 3211 and that is used to connect to the electronic element 2 is in a block shape, so that the connection reliability can be improved. During fabrication of the conductive structural member 32, after the plurality of bottom sub-plates 3211 are formed, the plurality of bottom sub-plates 3211 may be simultaneously bent to form the bulging segment R2, or after the bulging segment R2 is formed by bending the bottom plate 321, the plurality of bottom sub-plates 3211 may be formed through slotting.

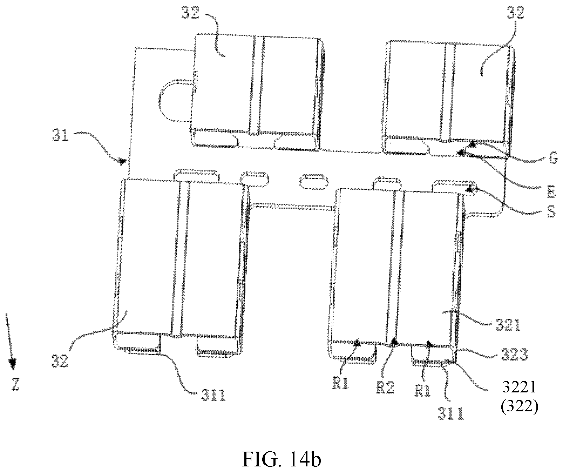

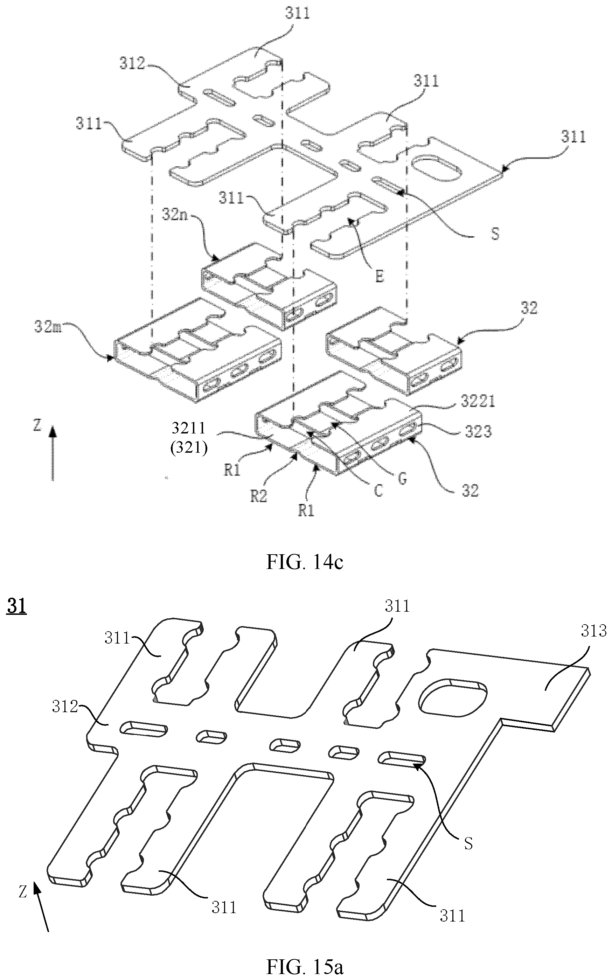

FIG. 14a and FIG. 14b show an example of a structure of the interconnection component 3. FIG. 14c is an exploded view of the interconnection component 3. As shown in FIG. 14a and FIG. 14b, the interconnection component 3 includes a conductive sheet 31 and a plurality of conductive structural members 32, and a structure of each conductive structural member 32 is similar to that of the conductive structural member 32 shown in FIG. 13b. Specifically, each conductive structural member 32 includes a bottom plate 321, a top plate 322, and at least one side plate 323. The top plate 322 includes two top sub-plates 3221, and each top sub-plate 3221 is connected to the bottom plate 321 via one side plate 323. The bottom plate 321 includes a plurality of bottom sub-plates 3211, and the through slot C is formed between any two bottom sub-plates 3211. The bottom plate 321 further includes two connection segments R1 and a bulging segment R2 connected between the two connection segments R1. An extension direction of the bulging segment R2 is disposed at an included angle with an arrangement direction of the two top sub-plates 3221.

Refer to FIG. 14a to FIG. 14c together. The conductive sheet 31 includes a plurality of connection parts 311 and an interconnection part 312 configured to connect to the plurality of connection parts 311. Each connection part 311 is configured to connect to one conductive structural member 32, and the interconnection part 312 is connected to each connection part 311. For ease of understanding, examples of the plurality of connection parts 311 are shown by using a plurality of dashed line boxes. Between the conductive structural member 32 and the connection part 311 that are connected to each other as a group, in the third direction Z, namely, a direction in which the conductive sheet 31 is connected to the conductive structural member 32, orthographic projection of the connection part 311 on the conductive structural member 32 at least partially overlaps the top plate 322. Specifically, in consideration of a manufacturing process and an assembly error, the orthographic projection of the connection part 311 on the top plate 322 basically falls within a range of the top plate 322.

In an embodiment, based on the two top sub-plates 3221 included in the top plate 322, a shape of the connection part 311 matches shapes of the two top sub-plates 3221, and the connection part 311 includes a slot opening E corresponding to the gap G between the two top sub-plates 3221, so that the materials and costs of the conductive sheet 31 can be reduced.

Still refer to FIG. 14a and FIG. 14b. The conductive sheet 31 includes a locking hole S, and the locking hole S penetrates the conductive sheet 31 in a thickness direction of the conductive sheet 31. During plastic packaging of the power module 10, the melted plastic packaging material may pass through the locking hole S and diffuse to two surfaces in the thickness direction of the conductive sheet 31, to enhance bonding strength between the plastic packaging material and the conductive sheet 31, and help improve the reliability of the module. To avoid a part that is of the conductive sheet 31 and that is used to connect to the conductive structural member 32, the locking hole S is disposed in a position of the interconnection part 312, that is, the locking hole S communicates with two surfaces of the interconnection part 312 in the thickness direction of the conductive sheet 31. When the conductive sheet 31 is connected to the plurality of conductive structural members 32, in the third direction Z, a port of the locking hole S on a surface that is of the conductive sheet 31 and that faces the plurality of conductive structural members 32 is located between adjacent conductive structural members 32, so that the locking hole S avoids the conductive structural member 32.

In an embodiment, as shown in FIG. 14c, the interconnection component 3 includes two types of conductive structural members 32, and basic structures of the two types of conductive structural members 32 are similar. The two types of conductive structural members 32 are respectively a conductive structural member 32m and a conductive structural member 32n. A difference between the two types of conductive structural members includes that, a size of the conductive structural member 32m perpendicular to the third direction Z is less than a size of the conductive structural member 32n perpendicular to the third direction Z. Specifically, in a direction perpendicular to the arrangement direction of the two top sub-plates 3221, the size of the conductive structural member 32m is less than the size of the conductive structural member 32n. The bottom plate 321 of the conductive structural member 32m includes three bottom sub-plates 3211, and the bottom plate 321 the conductive structural member 32n includes two bottom sub-plates 3211. It should be understood that shapes of different conductive structural members 32 need to be adaptively selected and adjusted based on a specification and a structure of the electronic element 2 to be connected.

FIG. 15a shows an example of a structure of the conductive sheet 31. As shown in FIG. 15a, the conductive sheet 31 includes a pin part 313, and the pin part 313 is configured to connect the conductive sheet 31 to the substrate 1. In an extension direction of the conductive sheet 31, the pin part 313 protrudes from a part that is of the conductive sheet 31 and that is configured to connect to the conductive structural member 32. For example, the pin part 313 is connected to at least one of the connection part 311 or the interconnection part 312. In an embodiment, the conductive sheet 31 is of an integrated structure, and the connection part 311, the interconnection part 312, and the pin part 313 may be formed by using a process like cutting or stamping.

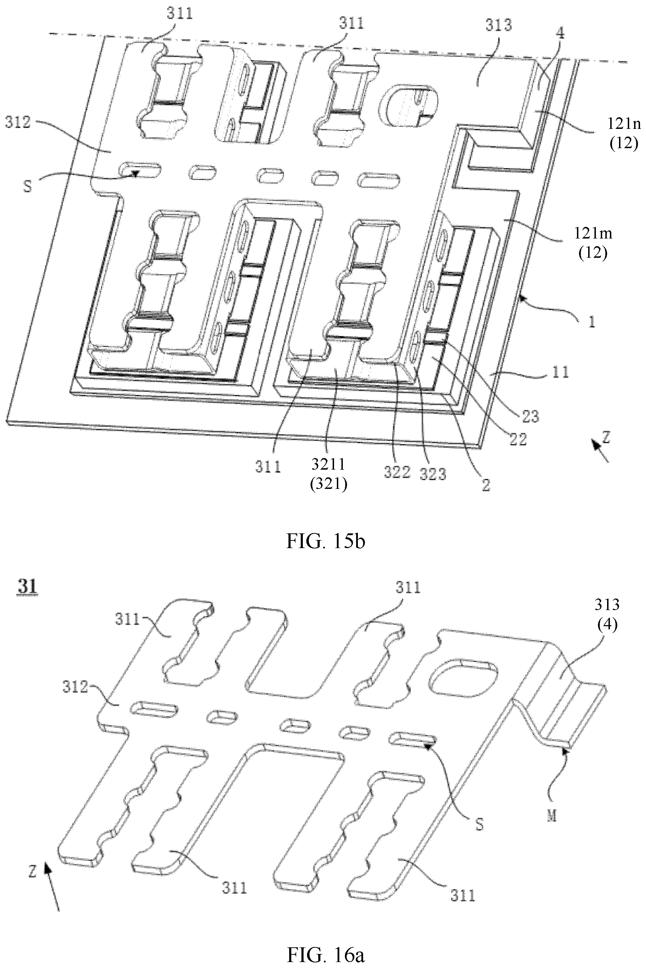

FIG. 15b shows a partial structure of the power module 10. The power module 10 includes the conductive sheet 31 shown in FIG. 15a. There is a gap between the pin part 313 of the conductive sheet 31 and the substrate 1, and the pin part 313 may be connected to the substrate 1 via the connector 4. In the third direction Z, orthographic projection of the pin part 313 on the substrate 1 at least partially overlaps a metal sublayer 121n, and the orthographic projection of the pin part 313 on the substrate 1 is spaced from each electronic element, to avoid structural interference or short circuit with the electronic element 2. Specifically, the first metal layer 12 of the substrate 1 includes a plurality of metal sublayers 121 that are isolated from each other, the plurality of electronic elements 2 to be connected to the conductive sheet 31 are disposed at a metal sublayer 121m, the first electrode 21 of each electronic element 2 is connected to the metal sublayer 121m, and the first electrode 21 is disposed on a side that is of the electronic element 2 and that faces the first metal layer 12 and is blocked and not shown herein. The second electrode 22 of each electronic element 2 is connected to the conductive sheet 31 via one conductive structural member 32, the second electrodes 22 of the plurality of electronic elements 2 are all electrically connected to the conductive sheet 31, and the conductive sheet 31 is connected to the metal sublayer 121n via the pin part 313 and the connector 4. The first electrodes 21 of the plurality of electronic elements 2 are all electrically connected to the metal sublayer 121m, and the second electrodes 22 of the plurality of electronic elements 2 are all electrically connected to the metal sublayer 121n, so that the plurality of electronic elements 2 are connected in parallel. Orthographic projection of each locking hole S on the conductive sheet 31 on the substrate 1 falls between two adjacent electronic elements 2, to avoid affecting a reliable connection between the conductive structural member 32 and the conductive sheet 31.

The connector 4 may be a metal copper block, a metal silver block, or another conductive pillar, to provide connection reliability.

FIG. 16a shows an example of a structure of the conductive sheet 31. As shown in FIG. 16a, the pin part 313 is in a bent shape, and the pin part 313 protrudes, in the third direction Z, from a surface that is of the conductive sheet 31 and that is configured to connect to the electronic element 2. The pin part 313 may be formed through bending, stamping, or the like. The conductive sheet 31 may be directly connected to the substrate 1 via the pin part 313 instead of the connector 4, and it may be considered that the connector 4 configured to connect to the substrate 1 is a part of the conductive sheet 31. The pin part 313 of the conductive sheet 31 is directly connected to the substrate 1. This can simplify a connection structure and facilitate module manufacturing.

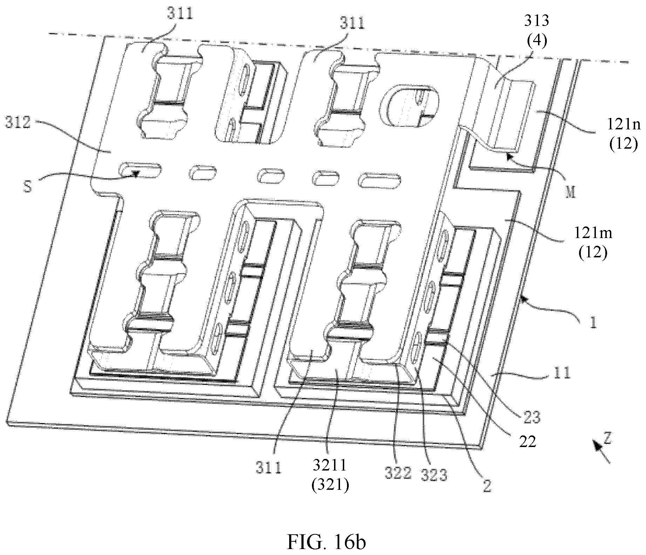

FIG. 16b shows a partial structure of the power module 10. The power module 10 includes the conductive sheet 31 shown in FIG. 16a, and the conductive sheet 31 is directly connected to the metal sublayer 121n of the substrate 1 via the pin part 313.

In an embodiment, as shown in both FIG. 16a and FIG. 16b, a free end of the pin part 313 includes a connection surface M parallel to the conductive sheet 31, and the connection surface M faces the substrate 1. When the conductive sheet 31 is connected to the metal sublayer 121n via the pin part 313, the connection surface M is in surface contact with the metal sublayer 121n, so that reliability of an electrical connection can be improved. For example, the pin part 313 is connected to one connection part 311. The free end of the pin part 313 is an end that is of the pin part 313 and that is away from the connection part 311, namely, an end that is of the pin part 313 and that is configured to connect to the metal sublayer 121n. When the pin part 313 is connected to the interconnection part 312, the free end of the pin part 313 is an end that is of the pin part 313 and that is away from the interconnection part 312.

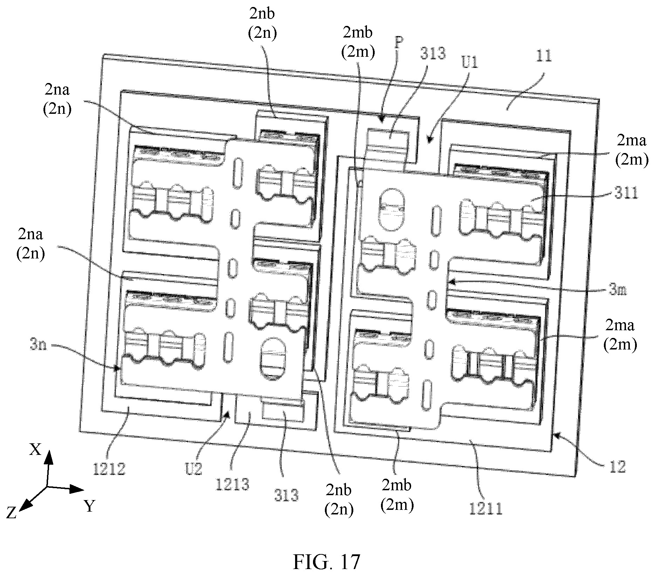

FIG. 17 is a diagram of a partial structure of the power module 10. The power module 10 is configured to implement power conversion between a direct current and an alternating current. The power module 10 includes two groups of electronic elements 2. The two groups of electronic elements 2 can be electrically connected to form a direct current-to-alternating current bridge arm circuit. The two groups of electronic elements 2 each implement circuit interconnection on a side that is of the two groups of electronic elements 2 and that faces away from the substrate 1 via one group of interconnection components 3. The first group of electronic elements 2 includes a plurality of electronic elements 2m, the second group of electronic elements 2 includes a plurality of electronic elements 2n, the plurality of electronic elements 2m included in the first group of electronic elements 2 can be connected in parallel to form an upper bridge arm, and the plurality of electronic elements 2n included in the second group of electronic elements 2 can be connected in parallel to form a lower bridge arm.

In an embodiment, in the substrate 1 of the power module 10, the plurality of metal sublayers 121 of the first metal layer 12 include a first metal sublayer 1211, a second metal sublayer 1212, and a third metal sublayer 1213, and the first metal sublayer 1211, the second metal sublayer 1212, and the third metal sublayer 1213 are isolated from each other. The first metal sublayer 1211 and the third metal sublayer 1213 are respectively configured to input a positive electrode and a negative electrode of a direct current, and the second metal sublayer 1212 is configured to output an alternating current. The plurality of electronic elements 2m included in the first group of electronic elements 2 are disposed at the first metal sublayer 1211, and each electronic element 2m is connected to the second metal sublayer 1212 via an interconnection component 3m. Specifically, each conductive structural member 32 in the interconnection component 3m is connected between one electronic element 2m and the conductive sheet 31, and the pin part 313 of the conductive sheet 31 is connected to the second metal sublayer 1212. In the direction perpendicular to the substrate, the interconnection component 3m corresponds to the first group of electronic elements 2, and an interconnection component 3n corresponds to the second group of electronic elements 2.

The plurality of electronic elements 2n included in the second group of electronic elements 2 are disposed at the second metal sublayer 1212, and the plurality of electronic elements 2n are connected to the third metal sublayer 1213 via the interconnection component 3n. Specifically, each conductive structural member 32 in the interconnection component 3n is connected between one electronic element 2n and the conductive sheet 31, and the pin part 313 of the conductive sheet 31 is connected to the third metal sublayer 1213.

In an embodiment, an input end and an output end of the power module 10 are opposite to each other in the first direction X, and the two groups of electronic elements 2 are spaced apart in the second direction Y. To save layout space of the substrate 1, a part that is of the second metal sublayer 1212 and that is close to the output end of the power module 10 extends toward the first metal sublayer 1211 in the second direction Y to form a protrusion part P, and the protrusion part P is configured to connect to the interconnection component 3m. A part that is of the first metal sublayer 1211 and that is close to the output end is recessed inward to form an opening U1, and the opening U1 may reserve layout space for the protrusion part P. The other part that is of the second metal sublayer 1212 and that is close to the input end of the power module 10 is recessed inward to a side that is of the second metal sublayer 1212 and that is away from the first metal sublayer 1211 to form an opening U2, and the third metal sublayer 1213 is disposed at the opening U2.

Based on a structure of the second metal sublayer 1212, arrangement of the plurality of electronic elements 2 may be adaptively adjusted, to optimize layout of the power module 10.

Still refer to FIG. 17. The first group of electronic elements 2 disposed at the first metal sublayer 1211 is used as an example. The plurality of electronic elements 2m include a plurality of first-type electronic elements 2ma and a plurality of second-type electronic elements 2mb, the plurality of first-type electronic elements 2ma are spaced apart in the first direction X, the plurality of second-type electronic elements 2mb are spaced apart in the first direction X, and the first-type electronic elements 2ma and the second-type electronic elements 2mb are different types of electronic elements. In the second direction Y, the plurality of first-type electronic elements 2ma are used as one group of electronic elements 2m, the plurality of second-type electronic elements 2mb are used as the other group of electronic elements 2m, and the two groups of electronic elements 2m are spaced apart. In the second direction Y, each first-type electronic element 2ma and one second-type electronic element 2mb are staggered, to avoid the opening U1 formed by recessing the first metal sublayer 1211 inward. In the first direction X, the opening U1 and the plurality of second-type electronic elements 2mb are spaced apart.

Still refer to FIG. 17. The second group of electronic elements 2 disposed at the second metal sublayer 1212 is used as an example. The plurality of electronic elements 2n include a plurality of first-type electronic elements 2na and a plurality of second-type electronic elements 2nb, the plurality of first-type electronic elements 2na are spaced apart in the first direction X, the plurality of second-type electronic elements 2nb are spaced apart in the first direction X, and the first-type electronic elements 2na and the second-type electronic elements 2nb are different types of electronic elements. In the second direction Y, the plurality of first-type electronic elements 2na are used as one group of electronic elements 2n, the plurality of second-type electronic elements 2nb are used as the other group of electronic elements 2n, and the two groups of electronic elements 2n are spaced apart. In the second direction Y, each first-type electronic element 2na and one second-type electronic element 2nb are staggered, to avoid the opening U2 formed by recessing the second metal sublayer 1212 inward. In the first direction X, the opening U2 and the plurality of second-type electronic elements 2nb are spaced apart.

In an embodiment, the third metal sublayer 1213 is arranged between the first metal sublayer 1211 and the second metal sublayer 1212 in the second direction Y. In the plurality of electronic elements 2m included in the first group of electronic elements 2, each second-type electronic element 2mb is arranged between the first-type electronic elements 2ma and the second group of electronic elements 2. In the plurality of electronic elements 2n included in the second group of electronic elements 2, each second-type electronic element 2nb is arranged between the first-type electronic elements 2na and the second group of electronic elements 2. In the second direction Y, the opening U1 of the first metal sublayer 1211 may be formed on a side that is of the first metal sublayer 1211 and that faces the second metal sublayer 1212, so that the interconnection component 3m is connected to the second metal sublayer 1212. In the second direction Y, the opening U2 of the second metal sublayer 1212 may be formed on a side that is of the second metal sublayer 1212 and that faces the first metal sublayer 1211, so that the interconnection component 3n is connected to the third metal sublayer 1213.

As shown in FIG. 17, a same type of electronic elements 2 have a same size, and different types of electronic elements 2 may have different sizes. The same type of electronic elements 2 are spaced apart in the first direction X, so that the plurality of electronic elements 2 can be regularly arranged based on different sizes, and the layout space of the substrate 1 can be more properly used. This helps reduce a region occupied by the plurality of electronic elements 2. Different types of electronic elements 2 are staggered in the second direction Y, and layout space of another structure or component may be reserved based on a circuit connection requirement, so that the space of the substrate 1 can further be properly laid out. Stress of different types of electronic elements 2 connected to the substrate 1 may be different. Regional layout is performed on the plurality of electronic elements 2 based on different types, so that stress distribution of the substrate 1 can be balanced, and the reliability of the module can be improved.

The plurality of electronic elements may be regularly arranged. This helps save arrangement space and reduce the stress between the electronic element and the substrate.

In some embodiments, both the first-type electronic element 2ma and the first-type electronic element 2na are insulated gate bipolar transistors (IGBT), and both the second-type electronic element 2mb and the second-type electronic element 2nb are fast recovery diodes (FRD).

It may be understood that FIG. 17 is merely intended to schematically describe an implementation of a partial structure of the power module 10, and is not to specifically limit structures included in the power module 10, a connection position of the structures, and specific structures and a quantity of structures. In some other embodiments of this application, the power module 10 may include more or fewer components than those shown in FIG. 17, or a combination of some components, or splits from some components, or a different component layout.

Based on the power module 10 provided in the foregoing embodiment, the power module 10 provided in this embodiment of this application may be implemented by using a plurality of process methods in a fabrication process. The following describes a method for fabricating the power module 10 by using a group of electronic elements 2 connected in parallel as an example.

In an embodiment, a substrate 1, a plurality of electronic elements 2, and a plurality of conductive structural members 32 may be first reflow soldered, so that a first electrode 21 of each electronic element 2 is connected to the substrate 1, and a second electrode 22 is connected to the one or more conductive structural members 32. Then, a signal electrode of each electronic element 2 is led out through wire bonding. Finally, the plurality of conductive structural members 32 are laser welded to a conductive sheet 31. In the fabrication method, only one time of reflow soldering is performed, so that impact of a high temperature in a soldering process on a component in the module can be reduced, and a warpage risk of the module can be reduced.

In an embodiment, each conductive structural member 32 may be first pre-connected to the conductive sheet 31 to form an interconnection component 3. Then, the substrate 1, the plurality of electronic elements 2, and the interconnection component 3 are reflow soldered, so that the first electrode 21 of each electronic element 2 is connected to the substrate 1, and the second electrode 22 is connected to the one or more conductive structural members 32. Finally, the signal electrode of each electronic element 2 is led out through wire bonding. In the fabrication method, only one time of reflow soldering is performed, so that the impact of the high temperature in the soldering process on the component in the module can be reduced, and the warpage risk of the module can be reduced.

In an embodiment, the substrate 1 and the plurality of electronic elements 2 may be first reflow soldered, so that the first electrode 21 of each electronic element 2 is connected to the substrate 1. Then, the signal electrode of each electronic element 2 is led out through wire bonding. Then, each conductive structural member 32 is pre-connected to the conductive sheet 31 to form the interconnection component 3. Finally, the plurality of electronic elements 2 and the interconnection component 3 are reflow soldered, so that the second electrode 22 of each electronic element 2 is connected to the one or more conductive structural members 32.

It should be understood that the power module 10 provided in this embodiment of this application may be further used in another power conversion field, to cope with an overload problem in an application scenario by using a high anti-overload capability, and improve a service life and energy efficiency of a product.

In the field of consumer electronics, the power module may be used in a device like a power adapter, an inverter, or a frequency converter. The power adapter is a power supply conversion device for a small portable electronic device and an electronic and electrical appliance. The power module is configured to convert electric energy and amplify power, and can convert an alternating current into a direct current to provide a stable and reliable power supply for the device, so as to ensure that the device can operate normally. The inverter is a power electronic apparatus including a semiconductor switch component. The power module can convert a direct current into an alternating current, and can implement efficient electric energy conversion in the inverter, to provide power support for places such as a home and an office.

In the power energy field, the power module may be used in a device like a solar inverter or a wind turbine converter. The solar inverter can convert a direct current generated by a solar cell panel into an alternating current and send the alternating current to a power grid. The power module is responsible for implementing efficient electric energy conversion and reliable power grid access, to provide power support for a home, an enterprise, and the like. The wind turbine converter is a device configured to control a rotational speed of a generator, adjust output power, and ensure stable running of a power grid in a wind power generation system. The power module can adjust the rotational speed and the output power of the generator based on a wind speed and a load change, to convert and control electric energy, and ensure safe and stable operation of the wind power generation system.

In the field of automotive electronics, the power module may be used in a device like an electric vehicle drive motor, a battery management system, and an electric power steering system. The electric vehicle drive motor is responsible for converting electric energy into mechanical energy to drive a vehicle to travel. The power module implements power amplification and control, and can accurately control a current and a voltage of the motor, to implement efficient and stable traveling performance. The battery management system is configured to perform charging/discharging control and protection on a battery of an electric vehicle. The power module performs electric energy conversion and protection, and can monitor a status of a battery and take a corresponding protection measure, to ensure safety and a long service life of the battery. Electric power steering is a device that upgrades a conventional mechanical steering system into an electronic steering system. The power module implements power amplification and control, and can provide appropriate assistance based on a steering intention of a driver, to improve driving comfort and safety.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises a substrate, at least one group of electronic elements, and at least one interconnection component;
each electronic element is disposed on the substrate, and each group of electronic elements comprises a plurality of electronic elements;
each interconnection component comprises a conductive sheet and a plurality of conductive structural members, each conductive sheet is spaced apart in a direction perpendicular to the substrate on a side that is of a group of electronic elements and that faces away from the substrate, and a surface that is of each electronic element in a same group of electronic elements and that faces away from the substrate is connected to one conductive sheet via one or more conductive structural members; and
each conductive structural member comprises a bottom plate, a top plate, and at least one side plate, the bottom plate is connected to the surface that is of the electronic element and that faces away from the substrate, the top plate is connected to the conductive sheet, and each side plate is connected between the bottom plate and the top plate.

2. The power module according to claim 1, wherein each electronic element comprises a plurality of second electrodes, and the plurality of second electrodes are disposed on the surface that is of the electronic element and that faces away from the substrate;
the bottom plate comprises a plurality of bottom sub-plates that are spaced apart, and each bottom sub-plate is configured to connect to one second electrode; and
in the direction perpendicular to the substrate, orthographic projection of each bottom sub-plate on one electronic element falls within a range of one second electrode.

3. The power module according to claim 1 or 2, wherein the bottom plate comprises two connection segments and a bulging segment, the bulging segment is connected between the two connection segments, each connection segment is configured to connect to the electronic element, and the bulging segment bulges in a direction away from the electronic element to avoid contact with the electronic element; and
in the direction perpendicular to the substrate, a height of the bulging segment is less than a height of the side plate.

4. The power module according to claim 3, wherein the electronic element comprises a gate bus, and the gate bus is disposed on the surface that is of the electronic element and that faces away from the substrate; and
a connection direction between the bulging segment and the two connection segments is disposed at an included angle with an extension direction of the gate bus.

5. The power module according to any one of claims 1 to 4, wherein each side plate comprises a through hole, and the through hole penetrates two surfaces in a thickness direction of the side plate.

6. The power module according to any one of claims 1 to 5, wherein the top plate comprises two top sub-plates, the two top sub-plates are spaced apart in a direction parallel to the substrate, and the two top sub-plates are respectively connected to two opposite sides of the bottom plate via two side plates.

7. The power module according to claim 6, wherein in an arrangement direction of the two top sub-plates, an edge that is of each top sub-plate and that is away from a connected side plate comprises a plurality of notches that are spaced apart.

8. The power module according to claim 6 or 7, wherein in the arrangement direction of the two top sub-plates, the two top sub-plates extend toward each other or away from each other.

9. The power module according to any one of claims 1 to 8, wherein in the direction perpendicular to the substrate, orthographic projection of the top plate on the substrate at least partially overlaps orthographic projection of the bottom plate on the substrate.

10. The power module according to any one of claims 1 to 9, wherein the conductive sheet comprises a locking hole, and the locking hole penetrates a surface that is of the conductive sheet and that faces the substrate and a surface that is of the conductive sheet and that faces away from the substrate; and
in the direction perpendicular to the substrate, orthographic projection of the locking hole on the substrate does not overlap orthographic projection of the plurality of conductive structural members on the substrate.

11. The power module according to any one of claims 1 to 10, wherein the conductive sheet comprises a pin part, and the pin part is configured to connect to the substrate; and
in the direction perpendicular to the substrate, orthographic projection of the pin part on the substrate is spaced from each electronic element.

12. The power module according to claim 11, wherein the pin part is bent in a direction toward the substrate to connect to the substrate; or
the pin part is connected to the substrate via a conductive pillar.

13. The power module according to any one of claims 1 to 12, wherein a same group of electronic elements comprises a first electronic element and a second electronic element; and
in the direction perpendicular to the substrate, a distance between the first electronic element and the conductive sheet is less than a distance between the second electronic element and the conductive sheet, and a height of a conductive structural member connected between the first electronic element and the conductive sheet is greater than a height of a conductive structural member connected between the second electronic element and the conductive sheet.

14. The power module according to any one of claims 1 to 13, wherein a same group of electronic elements comprises a plurality of first-type electronic elements and a plurality of second-type electronic elements;
in a first direction, the plurality of first-type electronic elements are spaced apart, and the plurality of second-type electronic elements are spaced apart;
in a second direction, one first-type electronic element and one second-type electronic element are staggered; and
the first direction and the second direction are parallel to the substrate and perpendicular to each other.

15. A power conversion device, wherein the power conversion device comprises a circuit board and the power module according to any one of claims 1 to 14, and the power module is electrically connected to the circuit board.
